(19) **Europäisches Patentamt / European Patent Office / Office européen des brevets**

(11) **EP 4 474 842 A1**

(12) **EUROPEAN PATENT APPLICATION**
published in accordance with Art. 153(4) EPC

(43) Date of publication:
**11.12.2024 Bulletin 2024/50**

(21) Application number: **23749620.3**

(22) Date of filing: **25.01.2023**

(51) International Patent Classification (IPC):
*G01R 31/392* (2019.01)     *G01R 31/379* (2019.01)
*H01M 10/48* (2006.01)     *H02J 7/00* (2006.01)

(52) Cooperative Patent Classification (CPC):
**G01R 31/379; G01R 31/392; H01M 10/48;**
**H02J 7/00;** Y02E 60/10

(86) International application number:
**PCT/JP2023/002260**

(87) International publication number:
**WO 2023/149304 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.02.2022 JP 2022015641**

(71) Applicants:
- **FURUKAWA ELECTRIC CO., LTD.**
  **Tokyo 100-8322 (JP)**
- **The Furukawa Battery Co., Ltd.**
  **Yokohama-shi, Kanagawa-ken 240-0006 (JP)**

(72) Inventors:
- **KUTSUMA Ayaka**
  **Tokyo 100-8322 (JP)**
- **NAKAMURA Hideto**
  **Tokyo 100-8322 (JP)**
- **TANIMURA Yudai**
  **Tokyo 100-8322 (JP)**
- **SATO Toshiyuki**
  **Yokohama-shi, Kanagawa 240-0006 (JP)**
- **YOSHIDA Hideaki**
  **Nikko-shi, Tochigi 321-2336 (JP)**

(74) Representative: **Grünecker Patent- und Rechtsanwälte**
**PartG mbB**
**Leopoldstraße 4**
**80802 München (DE)**

(54) **LEAD-ACID BATTERY SYSTEM AND LEAD-ACID BATTERY SERVICE LIFE ESTIMATION METHOD**

(57)     Provided are a lead-acid battery system and a lead-acid battery life estimation method capable of accurately estimating a remaining life of a lead-acid battery by calculating a capacity turnover value during operation (CT value during operation) in consideration of at least one of a lower limit state of charge (SOC) or a low SOC dwell time. A capacity turnover value calculation unit (138), (237), (337), or (440) of the lead-acid battery system (S) calculates the CT value during operation by using at least one of a lower-limit-SOC-based correction coefficient $K_{LSOC}$ calculated based on a lower limit SOC which is an SOC having the smallest value when the lead-acid battery (B) is charged and discharged once, respectively, or a low-SOC-dwell-time-based correction coefficient $K_{t\_LSOC}$ calculated based on a low SOC dwell time $t_{LSOC}$ which is an elapsed time until the next discharge or charge starts when a discharge ends below a reference SOC.

EP 4 474 842 A1

# FIG. 6

FROM LOWER LIMIT SOC
CALCULATION UNIT

138

CAPACITY TURNOVER
VALUE CALCULATION UNIT

PREVIOUS CAPACITY TURNOVER
VALUE ACQUISITION UNIT — 138a

INTEGRATED DISCHARGE
CAPACITY ACQUISITION UNIT — 138b

RATED CAPACITY ACQUISITION UNIT — 138c

LOWER LIMIT SOC ACQUISITION UNIT — 138d

LOWER−LIMIT−SOC−BASED CORRECTION
COEFFICIENT CALCULATION UNIT — 138e

FROM
RECORDING
UNIT

LOWER SOC DWELL
TIME ACQUISITION UNIT — 138f

LOWER−SOC−DWELL−TIME−BASED
CORRECTION COEFFICIENT
CALCULATION UNIT — 138g

CAPACITY TURNOVER
VALUE COMPUTATION UNIT — 138h

TO LIFE ESTIMATION UNIT

## Description

Technical Field

The present invention relates to a lead-acid battery system and a lead-acid battery life estimation method for estimating a remaining life of a lead-acid battery.

Background Art

In recent years, power generation facilities using natural energy such as sunlight and wind power have increased. In such a power generation facility, the amount of power generated cannot be controlled, and thus a storage battery is used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in a case of various storage batteries as described above, it is known that deterioration progresses with use and available battery capacity decreases. These storage batteries are not replaced immediately when their capacity is depleted after a single discharge unlike primary batteries, but are repeatedly used. Thus, it is required to appropriately grasp the state of installed storage batteries.

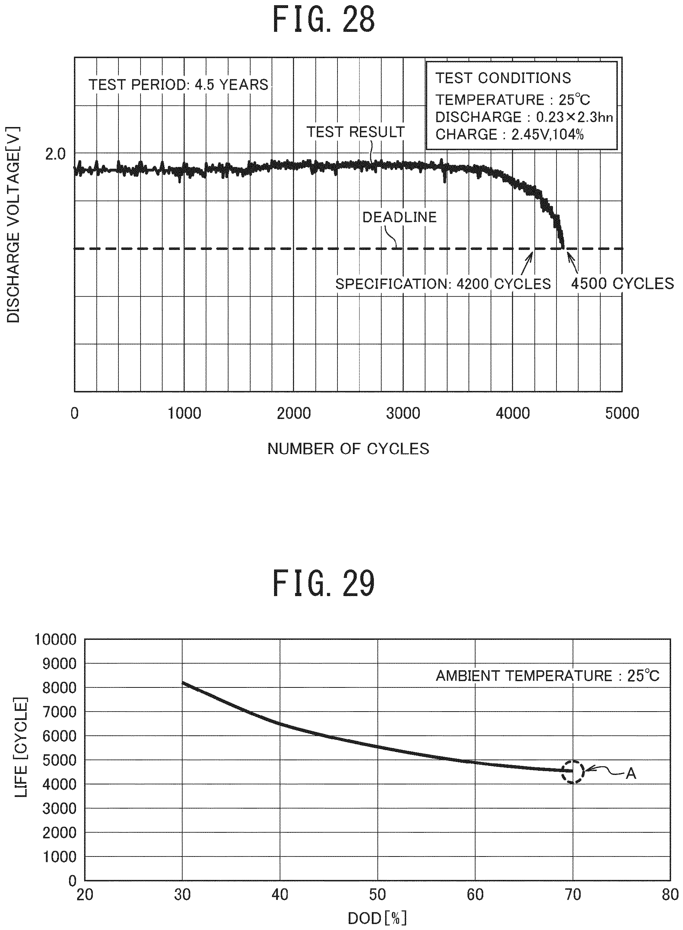

Here, an example of a cycle characteristic of a general lead-acid battery will be described. As illustrated in FIG. 28, a decrease in capacity of the lead-acid battery due to deterioration occurs, for example, from around 3900 cycles with respect to 4500 cycles of life, and there is a possibility that a characteristic change is not observed until the end of the life of the lead-acid battery.

A main factor of the decrease in capacity of the lead-acid battery is a decrease in adhesion between a positive electrode grid and an active material. From the viewpoint of energy density, in a bipolar lead-acid battery that has attracted attention in recent years, there is a possibility that a further rapid decrease in capacity may occur toward the end of life.

In view of the possibility that a characteristic change (capacity decrease) is not observed until the end of the life of the lead-acid battery as described above, it has been hitherto performed to estimate the life of the lead-acid battery from a capacity turnover value (CT value), which is an index related to the number of discharges.

Here, the capacity turnover value is a value obtained by dividing the total discharge capacity by a rated capacity of the storage battery, and is used as a life index of the storage battery. In a cycle charge/discharge lead-acid battery, the number of discharges (cycle life) from the beginning to the end of life is obtained under certain conditions, and the capacity turnover value from the beginning to the end of life can be calculated. FIG. 29 illustrates an example of a relationship between a DOD representing a depth of discharge and the life of the storage battery. In a case where a lead-acid battery having a rated capacity of 1000 Ah as indicated by an arrow A is dischargeable for 4500 cycles with a DOD of 70%, the capacity turnover value from the beginning to the end of life is total discharge capacity (1000 Ah $\times$ 70% $\times$ 4500 cycles)/rated capacity (1000 Ah) = 3150 (times).

Therefore, the remaining life of the lead-acid battery can be estimated by comparing the capacity turnover value from the beginning to the end of life with the capacity turnover value during operation.

On the other hand, as a conventional lead-acid battery life prediction method, for example, a method described in PTL 1 is known.

The lead-acid battery life prediction method described in PTL 1 integrates a charged electricity amount from a charge current value of a lead-acid battery, and predicts a life of the lead-acid battery from the integrated value. In the lead-acid battery life prediction method described in PTL 1, a relationship between a charging battery voltage and a battery temperature and a charging current is measured in advance using a standard lead-acid battery, a charging battery voltage and a battery temperature of a target lead-acid battery are detected, and a charge current value is determined based on the detected values and the above-described relationship.

Citation List

Patent Literature

PTL 1: JP H2-288074 A

Summary of Invention

Technical Problem

However, in the conventional lead-acid battery life prediction method described in PTL 1, in prediction of a life of a lead-acid battery, a charged electricity amount is integrated from a charge current value of the lead-acid battery, and the life of the lead-acid battery is predicted from the integrated value, and a remaining life of the lead-acid battery is not estimated by comparing the above-described capacity turnover value from the beginning to the end of life and the capacity turnover value during operation. Therefore, it is difficult to accurately estimate the remaining life of the lead-acid battery.

On the other hand, it is considered that in the lead-acid battery, a growth depth of lead sulfate is large in a low state-of-charge (SOC) region (for example, an SOC is 30% or less), and an influence of deterioration due to sulfation or softening of an active material is large. Therefore, in order to calculate the capacity turnover value during operation, in a case where the SOC of the lead-acid battery is in the low SOC region, it is desirable to consider the SOC, particularly, a lower limit SOC (an SOC having the smallest value when the lead-acid battery is discharged and charged once, respectively). Here, the SOC means the state of charge, and is obtained by dividing the sum of the rated capacity and the total charge amount and the total discharge amount (negative value) from completion of an equalization charge to a corresponding time point by the rated capacity, assuming that the SOC when the equalization charge is completed is 100%. The SOC can be expressed by the following Formula (1).
[Mathematical Formula 1]

$$SOC = \frac{(\text{Rated capacity} + \text{Total charge amount} + \text{Total discharge amount})}{\text{Rated capacity}} \times 100 \quad \cdots \quad (1)$$

In addition, in the lead-acid battery, there is Ostwald ripening, and the Ostwald ripening has a large influence on the low SOC region of the lead-acid battery. Therefore, it is desirable to calculate the capacity turnover value during operation in consideration of a low SOC dwell time (an elapsed time until the next discharge or charge starts when a discharge ends below a reference SOC). Here, the Ostwald ripening refers to a phenomenon in which a plurality of crystal grains having different grain sizes present in the same parent phase grow into a larger crystal grain using a difference in interfacial energy as a driving force.

Therefore, an object of the present invention is to provide a lead-acid battery system and a lead-acid battery life estimation method capable of accurately estimating a remaining life of a lead-acid battery by calculating a capacity turnover value during operation in consideration of at least one of a lower limit SOC or a low SOC dwell time.

Solution to Problem

A lead-acid battery system according to an aspect of the present invention is a lead-acid battery system configured to estimate a remaining life of a lead-acid battery by comparing a capacity turnover value from a beginning to an end of life with a capacity turnover value during operation, the lead-acid battery system including: a capacity turnover value calculation unit configured to calculate the capacity turnover value during operation, in which the capacity turnover value calculation unit calculates the capacity turnover value during operation by using at least one of a lower-limit-state-of-charge (SOC)-based correction coefficient calculated based on a lower limit SOC calculated by a lower limit SOC calculation unit configured to calculate the lower limit SOC which is an SOC having a smallest value when the lead-acid battery is charged and discharged once, respectively, or a low-SOC-dwell-time-based correction coefficient calculated based on a low SOC dwell time which is an elapsed time until a next discharge or charge starts when a discharge ends below a reference SOC.

A lead-acid battery life estimation method according to another aspect of the present invention is a lead-acid battery life estimation method in which a remaining life of a lead-acid battery is estimated by comparing a capacity turnover value from a beginning to an end of life and a capacity turnover value during operation, the lead-acid battery life estimation method including: a capacity turnover value calculation step of calculating the capacity turnover value during operation, in which in the capacity turnover value calculation step, the capacity turnover value during operation is calculated using at least one of a lower-limit-SOC-based correction coefficient calculated based on a lower limit SOC calculated in a lower limit SOC calculation step of calculating the lower limit SOC which is an SOC having a smallest value when the lead-acid battery is charged and discharged once, respectively, or a low-SOC-dwell-time-based correction coefficient calculated based on a low SOC dwell time which is an elapsed time until a next discharge or charge starts when a discharge ends below a reference SOC.

Advantageous Effects of Invention

In the lead-acid battery system according to the present invention, the capacity turnover value calculation unit calculates the capacity turnover value during operation by using at least one of the lower-limit-SOC-based correction coefficient calculated based on the lower limit SOC calculated by the lower limit SOC calculation unit configured to calculate the lower limit SOC which is the SOC having the smallest value when the lead-acid battery is charged and discharged once, respectively, or the low-SOC-dwell-time-based correction coefficient calculated based on the low SOC dwell time which is the elapsed time until the next discharge or charge starts when a discharge ends below the reference SOC. As a result, it is possible to calculate the capacity turnover value during operation in consideration of at least one of the lower limit SOC or the low SOC dwell time, to consider the progress of deterioration due to softening or sulfation of the active material, and to provide the lead-acid battery system capable of accurately estimating the remaining life of the lead-acid battery.

In the lead-acid battery system according to the present invention, the lower limit SOC calculation unit calculates, as the lower limit SOC, an SOC after an end of a discharge of the lead-acid battery to be subjected to calculation of the capacity turnover value during operation, and the capacity turnover value calculation unit calculates the lower-limit-SOC-based correction coefficient based on the lower limit SOC calculated by the lower limit SOC calculation unit. As a result, the lower limit SOC can be determined and calculated after the end of the discharge to be subjected to calculation of the capacity turnover value during operation, and the lower-limit-SOC-based correction coefficient can be appropriately calculated based on the calculated lower limit SOC.

In the lead-acid battery system according to the present invention, the lower limit SOC calculation unit calculates, as the lower limit SOC, an SOC at a start of a charge immediately before a discharge of the lead-acid battery to be subjected to calculation of the capacity turnover value during operation, and the capacity turnover value calculation unit calculates the lower-limit-SOC-based correction coefficient based on the lower limit SOC calculated by the lower limit SOC calculation unit. As a result, the lower limit SOC can be determined and calculated at the start of the charge immediately before the discharge to be subjected to calculation of the capacity turnover value during operation, and the lower-limit-SOC-based correction coefficient can be appropriately calculated based on the calculated lower limit SOC.

In the lead-acid battery system of the present invention, the lead-acid battery is a bipolar lead-acid battery. Accordingly, it is possible to provide the lead-acid battery system capable of accurately estimating the remaining life of the bipolar lead-acid battery.

n the lead-acid battery life estimation method according to the present invention, in the capacity turnover value calculation step, the capacity turnover value during operation is calculated using at least one of the lower-limit-SOC-based correction coefficient calculated based on the lower limit SOC calculated in the lower limit SOC calculation step of calculating the lower limit SOC which is the SOC having the smallest value when the lead-acid battery is charged and discharged once, respectively, or the low-SOC-dwell-time-based correction coefficient calculated based on the low SOC dwell time which is the elapsed time until the next discharge or charge starts when a discharge ends below the reference SOC. It is possible to calculate the capacity turnover value during operation in consideration of at least one of the lower limit SOC or the low SOC dwell time, to consider the progress of deterioration due to softening or sulfation of the active material, and to provide the lead-acid battery life estimation method capable of accurately estimating the remaining life of the lead-acid battery.

In the lead-acid battery life estimation method according to the present invention, in the lower limit SOC calculation step, an SOC after an end of a discharge of the lead-acid battery to be subjected to calculation of the capacity turnover value during operation is calculated as the lower limit SOC, and in the capacity turnover value calculation step, the lower-limit-SOC-based correction coefficient is calculated based on the lower limit SOC calculated in the lower limit SOC calculation step. As a result, the lower limit SOC can be determined and calculated after the end of the discharge of the lead-acid battery to be subjected to calculation of the capacity turnover value during operation, and the lower-limit-SOC-based correction coefficient can be appropriately calculated based on the calculated lower limit SOC.

In the lead-acid battery life estimation method according to the present invention, in the lower limit SOC calculation step, an SOC at a start of a charge immediately before a discharge of the lead-acid battery to be subjected to calculation of the capacity turnover value during operation is calculated as the lower limit SOC, and in the capacity turnover value calculation step, the lower-limit-SOC-based correction coefficient is calculated based on the lower limit SOC calculated in the lower limit SOC calculation step. As a result, the lower limit SOC can be determined and calculated at the start of the charge immediately before the discharge of the lead-acid battery to be subjected to calculation of the capacity turnover value during operation, and the lower-limit-SOC-based correction coefficient can be appropriately calculated based on the calculated lower limit SOC.

In the lead-acid battery life estimation method of the present invention, the lead-acid battery is a bipolar lead-acid battery. Accordingly, it is possible to provide the lead-acid battery life estimation method capable of accurately estimating the remaining life of the bipolar lead-acid battery.

Brief Description of Drawings

FIG. 1 is a block diagram illustrating an overall configuration of lead-acid battery systems according to first to fourth embodiments of the present invention;

FIG. 2 is a block diagram illustrating an internal configuration of battery management units (BMUs) included in the lead-acid battery systems according to the first to fourth embodiments of the present invention illustrated in FIG. 1;

FIG. 3 is a diagram for describing start and end timings of processing in a state determination unit and calculation of a state of charge (SOC) after the end of a discharge to be subjected to calculation of a capacity turnover value during operation as a lower limit SOC in the lead-acid battery system according to the first to third embodiments of the present invention;

FIG. 4 is a block diagram illustrating internal configurations of a recording unit and a state determination unit included in the BMU illustrated in FIG. 2 in the lead-acid battery system according to the first embodiment of the present invention;

FIG. 5 is a diagram for describing a low SOC dwell time;

FIG. 6 is a block diagram illustrating an internal configuration of a capacity turnover value calculation unit included in the state determination unit illustrated in FIG. 4;

FIG. 7 is a flowchart illustrating a flow of processing in the state determination unit illustrated in FIG. 4;

FIG. 8 is a flowchart illustrating a flow of processing of step S9 (capacity turnover value calculation step) in the flowchart illustrated in FIG. 7;

FIG. 9 is a graph illustrating a relationship between the lower limit SOC and a lower-limit-SOC-based correction coefficient;

FIG. 10 is a graph illustrating a relationship between the low SOC dwell time and a low-SOC-dwell-time-based correction coefficient;

FIG. 11 is a block diagram illustrating internal configurations of a recording unit and the state determination unit included in the BMU illustrated in FIG. 2 in the lead-acid battery system according to the second embodiment of the present invention;

FIG. 12 is a block diagram illustrating an internal configuration of a capacity turnover value calculation unit included in the state determination unit illustrated in FIG. 11;

FIG. 13 is a flowchart illustrating a flow of processing in the state determination unit illustrated in FIG. 11;

FIG. 14 is a flowchart illustrating a flow of processing of step S108 (capacity turnover value calculation step) in the flowchart illustrated in FIG. 13;

FIG. 15 is a block diagram illustrating internal configurations of a recording unit and the state determination unit included in the BMU illustrated in FIG. 2 in the lead-acid battery system according to the third embodiment of the present invention;

FIG. 16 is a block diagram illustrating an internal configuration of a capacity turnover value calculation unit included in the state determination unit illustrated in FIG. 15;

FIG. 17 is a flowchart illustrating a flow of processing in the state determination unit illustrated in FIG. 15;

FIG. 18 is a flowchart illustrating a flow of processing of step S208 (capacity turnover value calculation step) in the flowchart illustrated in FIG. 17;

FIG. 19 is a diagram for describing start and end timings of processing in a state determination unit and calculation of an SOC at the start of a charge immediately before a discharge to be subjected to calculation of the capacity turnover value during operation as the lower limit SOC in the lead-acid battery system according to the fourth embodiment of the present invention;

FIG. 20 is a block diagram illustrating internal configurations of a recording unit and the state determination unit included in the BMU illustrated in FIG. 2 in the lead-acid battery system according to the fourth embodiment of the present invention;

FIG. 21 is a block diagram illustrating an internal configuration of a capacity turnover value calculation unit included in the state determination unit illustrated in FIG. 20;

FIG. 22 is a flowchart illustrating a flow of processing in the state determination unit illustrated in FIG. 20;

FIG. 23 is a flowchart illustrating a flow of processing of step S411 (capacity turnover value calculation step) in the flowchart illustrated in FIG. 22;

FIG. 24 is a diagram for describing another calculation method in a case where an SOC after the end of the discharge to be subjected to calculation of the capacity turnover value during operation is calculated as the lower limit SOC;

FIG. 25 is a diagram for describing still another calculation method in a case where the SOC after the end of the discharge to be subjected to calculation of the capacity turnover value during operation is calculated as the lower limit SOC;

FIG. 26 is a diagram for describing another calculation method in a case where an SOC at the start of a charge immediately before a discharge to be subjected to calculation of the capacity turnover value during operation is calculated as the lower limit SOC;

FIG. 27 is a diagram for describing still another calculation method for the lower limit SOC determined at the start of a charge immediately before a discharge;

FIG. 28 is a graph for describing an example of a cycle characteristic of a general lead-acid battery; and

FIG. 29 is a graph illustrating an example of a relationship between a DOD representing a depth of discharge and a life of a storage battery.

Description of Embodiments

Hereinafter, an embodiment of the present invention will be described in detail with reference to the drawings. Note that the embodiment described below illustrates an example of the present invention. In addition, various changes or improvements can be added to the present embodiment, and a mode to which such changes or improvements are added can also be included in the present invention. The embodiment and modifications thereof are included in the scope and gist of the invention, and are included in the scope of the invention described in the claims and its equivalents.

(First Embodiment)

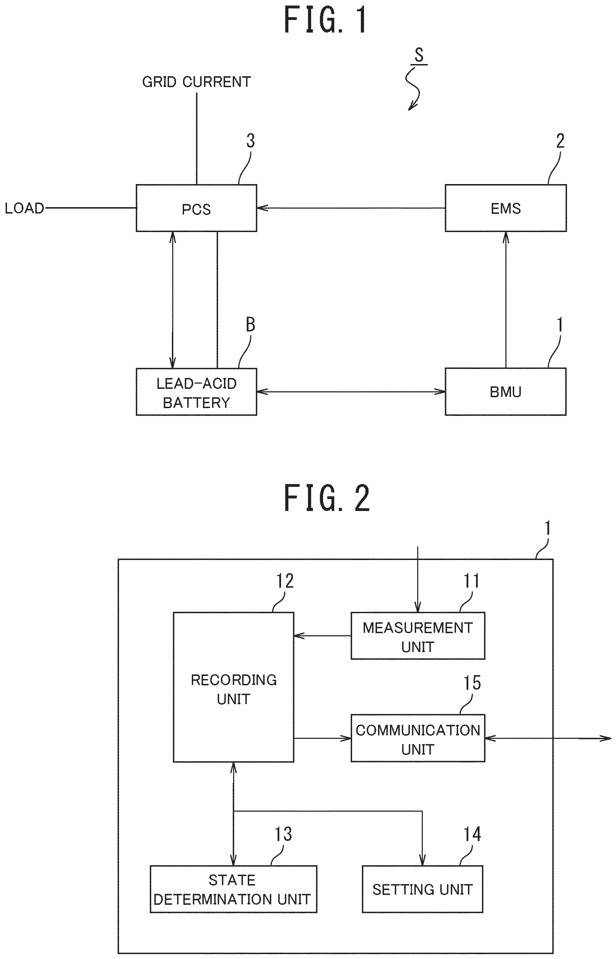

FIG. 1 illustrates an overall configuration of lead-acid battery systems according to the first embodiment of the present invention and the second to fourth embodiments described below.

A lead-acid battery system S illustrated in FIG. 1 is a system that stores, in a lead-acid battery B, a grid current generated by various power plants such as thermal power plants or from renewable energy such as wind power generation and transmitted, and transmits the power stored in the lead-acid battery B to a load such as a home, an office, or a factory as necessary. The lead-acid battery system S includes a BMU 1, an EMS 2, and a PCS 3 in addition to the lead-acid battery B.

The BMU 1 is a battery management unit and is a device that manages a voltage of each of cells included in the lead-acid battery B, a temperature of the entire lead-acid battery B, and the like. Thus, the BMU 1 can grasp a state of the lead-acid battery B via a sensor that is provided in the lead-acid battery B and acquires various types of information.

In addition, the BMU 1 estimates a remaining life of the lead-acid battery B by comparing a capacity turnover value from the beginning to the end of life with a capacity turnover value during operation. Therefore, the BMU 1 includes a life estimation program necessary for the estimation.

Note that a function of the BMU 1 is not limited to the function described here, and may include other functions such as managing the balance of voltages in the respective cells, for example.

The BMU 1 is a computer system having an arithmetic processing function, and can implement each function on software by executing various dedicated computer programs stored in advance in hardware. In addition, the BMU 1 may be installed near the lead-acid battery B, or may be configured to be managed on a cloud or managed remotely. A detailed configuration of the BMU 1 will be described later.

The EMS 2 is a so-called energy management system, and is a system that grasps, manages, and optimizes a use state of power energy. In addition, the PCS 3 is a power conditioning system, and serves a role of converting a direct current generated from a grid current or the like into an alternating current and adjusting the alternating current to an output to the load or a stable output suitable for storage in the lead-acid battery B.

The lead-acid battery B is a secondary battery using lead as an electrode. As the lead-acid battery B, a bipolar lead-acid battery is preferably applied, but any structure may be used, and the number of installations, an installation method, and the like are not limited, and any setting can be used. In the lead-acid battery B, information acquired from various sensors to be described later (sensor information) is transmitted to the BMU 1, but a transmission/reception device or the like for transmitting the acquired sensor information to the BMU 1 and receiving, for example, a command from the PCS 3 is provided.

The lead-acid battery B includes various sensors (not illustrated in FIG. 1) for acquiring corresponding operation history information. The various sensors are sensors that acquire information indicating an operation history or state of the lead-acid battery B such as a current, a voltage, or a temperature. These sensors may be provided for each unit or for each individual lead-acid battery B.

In the lead-acid battery system S according to the first embodiment and the second to fourth embodiments described below, the direct current from the grid current from the power plant such as a thermal power plant or renewable energy is converted into the alternating current in the PCS 3, and output to the load or storage in the lead-acid battery B is performed.

As will be described later, the BMU 1 estimates the remaining life of the lead-acid battery B, grasps a charge rate, the degree of deterioration, and the like of the lead-acid battery B, and issues an operation command to the EMS 2 according to the state of the lead-acid battery B. This operation command is further transmitted to the PCS 3 to appropriately issue a command for charging or discharging the lead-acid battery B and perform the above-described output to the load and the like.

As illustrated in FIG. 1, the BMU 1, the EMS 2, the PCS 3, and the lead-acid battery B are exemplified as four constituent elements of the lead-acid battery system S, but the constituent elements of the lead-acid battery system S are not limited thereto. It is also possible to impart the functions of the EMS 2 and the PCS 3 to the BMU 1, and in this case, the lead-acid battery system S is constituted by the BMU 1 and the lead-acid battery B.

Next, the BMU 1 will be described in more detail. FIG. 2 is a block diagram illustrating an internal configuration of the BMUs included in the lead-acid battery systems illustrated in FIG. 1 according to the first embodiment of the present invention and the second to fourth embodiments described below.

The BMU 1 includes a measurement unit 11, a recording unit 12, a state determination unit 13, a setting unit 14, and a communication unit 15.

The measurement unit 11 receives information regarding a measured value such as a current, a voltage, or a temperature measured via the above-described various sensors provided in the lead-acid battery B. Note that the measurement unit 11 may be set to continuously receive the above-described information, or may receive the above-described information between two time points arbitrarily set in advance. Alternatively, the measurement unit 11 may be set to periodically receive the information.

The recording unit 12 records information regarding the measured value received from the various sensors by the measurement unit 11, information exchanged with the EMS 2, information necessary for calculating the capacity turnover value during operation and the capacity turnover value from the beginning to the end of life (for example, a rated capacity or the like of the lead-acid battery B), a result of processing executed by the state determination unit 13 (the remaining life of the lead-acid battery B and the capacity turnover value during operation calculated by state determination unit 13), and the like. In addition, the total charge amount and the total discharge amount of the lead-acid battery B from the beginning of operation to a corresponding time point are constantly calculated based on a current value when the lead-acid battery B is charged and discharged, the current value being received from a current sensor by the measurement unit 11, and the total charge amount and the total discharge amount of the lead-acid battery B from the beginning of operation to the corresponding time point are constantly recorded in the recording unit 12.

The state determination unit 13 determines the state of the lead-acid battery B, specifically, estimates the remaining life of the lead-acid battery B by comparing the capacity turnover value from the beginning to the end of life and the capacity turnover value during operation. Here, as described above, the capacity turnover value is a value obtained by dividing a total discharge capacity by a rated capacity of a storage battery, and is used as a life index of the storage battery. The capacity turnover value from the beginning to the end of life is determined by dividing the total discharge capacity from the beginning to the end of life by the rated capacity of the storage battery. For example, in the example illustrated in FIG. 29, in a case where a lead-acid battery having a rated capacity of 1000 Ah as indicated by an arrow A is dischargeable for 4500 cycles with a DOD of 70%, the capacity turnover value from the beginning to the end of life (hereinafter, referred to as a CT value from the beginning to the end of life) is total discharge capacity (1000 Ah $\times$ 70% $\times$ 4500 cycles)/rated capacity (1000 Ah) = 3150 (times). In addition, the capacity turnover value during operation is calculated by a method described below.

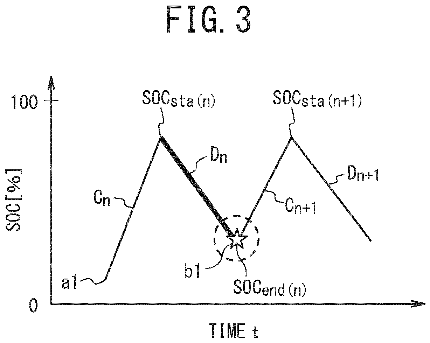

The processing in the state determination unit 13 is executed as needed in normal operation, for example. For example, in the first embodiment, as illustrated in FIG. 3, the processing in the state determination unit 13 is executed from a time point a1 at the time of the n-th charge Cn of the lead-acid battery B to a time point b1 after the end of the n-th discharge Dn, and the processing is repeated at the time of charging and discharging.

The setting unit 14 sets, for example, a first threshold, a second threshold, and the like of a current value used for charge/discharge determination, which are used when the state determination unit 13 determines the state of the lead-acid battery B, specifically, estimates the remaining life of the lead-acid battery B, and transmits the set information to the recording unit 12. In setting the thresholds, an input unit and a display unit (not illustrated in FIG. 2) are used.

The communication unit 15 transmits the result of the processing in the state determination unit 13 recorded in the recording unit 12 to the EMS 2.

The BMU 1 is a computer system having an arithmetic processing function as described above and has a configuration in which a central processing unit (CPU), a read only memory (ROM), a random access memory (RAM), and an input/output interface are connected via a bus. In addition, the input unit and the display unit used by a person who manages the lead-acid battery system S are connected to the input/output interface, and each unit illustrated in FIG. 2 described above is connected to the input/output interface.

The CPU reads and executes a boot program for activating the BMU 1 from the ROM based on an input signal from the input unit, and reads various operating systems stored in the recording unit 12. The CPU may control the lead-acid battery B or the like based on an input signal from another external device (not illustrated in FIG. 2) via the input unit or the input/output interface.

Further, the CPU is a processing device that reads a program and data stored in the RAM, the recording unit 12, or the like and loads the program and the data into the RAM, and implements a series of processing such as calculation and processing of data necessary for estimating the remaining life of the lead-acid battery B based on a command of the program read from the RAM.

The input unit is implemented by an input device such as a touch panel to which a person who manages the lead-acid battery system S inputs various operations, and an input signal is created based on the operation of the manager and transmitted to the CPU via the bus.

The display unit is, for example, a liquid crystal display. The display unit receives an output signal from the CPU via the bus and displays a processing result of the CPU.

In a case where the BMU 1 itself is operated by remote control, for example, the input unit and the display unit do not have to be provided inside the BMU 1. The BMU 1 may have functions other than the above-described units.

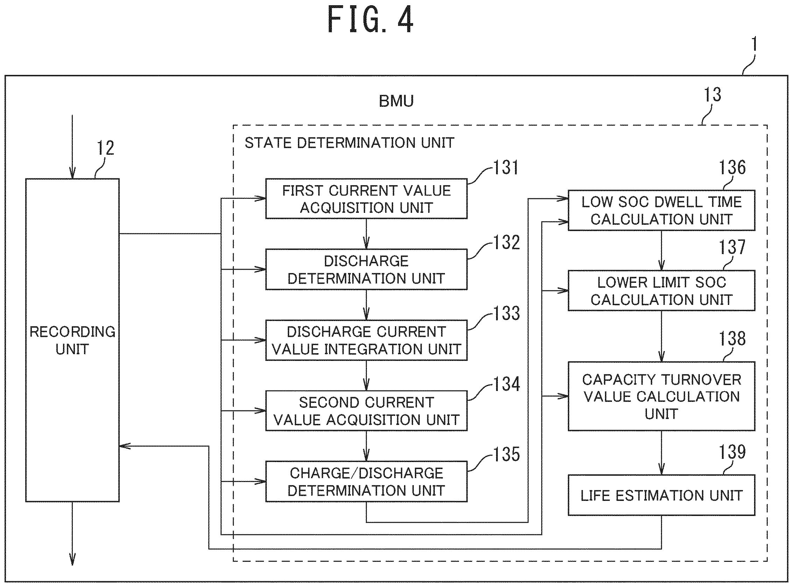

Next, internal configurations of the recording unit 12 and the state determination unit 13 will be described in more detail below. FIG. 4 is a block diagram illustrating the internal configurations of the recording unit 12 and the state determination unit 13 included in the BMU 1 illustrated in FIG. 2 in the lead-acid battery system S according to the first embodiment of the present invention.

The recording unit 12 is implemented by, for example, a semiconductor or a magnetic disk. The recording unit 12 records information regarding a measured value from various sensors received by the measurement unit 11. The recording unit 12 records, for example, information regarding a current value and a voltage value when the lead-acid battery B is charged or discharged, or information regarding the temperature of the lead-acid battery B, information exchanged with the EMS 2, information necessary for calculating the capacity turnover value during operation and the capacity turnover value from the beginning to the end of life (for example, the rated capacity or the like of the lead-acid battery B), a result of processing executed by the state determination unit 13 (the remaining life of the lead-acid battery B and the capacity turnover value during operation calculated by state determination unit 13), and the like. In addition, the total charge amount and the total discharge amount (negative value) from completion of an equalization charge of the lead-acid battery B to the corresponding time point are constantly calculated based on the current value when the lead-acid battery B is charged and discharged, the current value being received from the current sensor by the measurement unit 11, and the total charge amount and the total discharge amount (negative value) from the completion of the equalization charge to the corresponding time point are constantly recorded in the recording unit 12.

As will be described later, the state determination unit 13 of the first embodiment calculates a lower limit SOC which is an SOC having the smallest value when the lead-acid battery B is charged and discharged once, respectively. Then, the state determination unit 13 calculates the capacity turnover value during operation by using both a lower-limit-SOC-based correction coefficient $K_{LSOC}$ calculated based on the calculated lower limit SOC and a low-SOC-dwell-time-based correction coefficient $K_{t\_LSOC}$ calculated based on a low SOC dwell time $t_{LSOC}$ which is an elapsed time until the next discharge or charge starts when a discharge ends below a reference SOC.

Then, as illustrated in FIG. 3, the state determination unit 13 of the first embodiment calculates $SOC_{end(n)}$ after the end of a discharge (n-th discharge Dn) of the lead-acid battery B to be subjected to calculation of the capacity turnover value during operation as the lower limit SOC.

Therefore, the state determination unit 13 includes a first current value acquisition unit 131, a discharge determination unit 132, a discharge current value integration unit 133, a second current value acquisition unit 134, a charge/discharge determination unit 135, a low SOC dwell time calculation unit 136, a lower limit SOC calculation unit 137, a capacity turnover value calculation unit 138, and a life estimation unit 139 in order to estimate the remaining life of the lead-acid battery B.

The first current value acquisition unit 131 acquires, from the recording unit 12, information regarding a current value of the lead-acid battery B input to the recording unit 12 via the measurement unit 11 from the start to the end of the processing in the state determination unit 13.

In addition, the discharge determination unit 132 determines whether or not the lead-acid battery B is in a discharge state based on the current value of the lead-acid battery B acquired by the first current value acquisition unit 131. Specifically, in a case where the current value of the lead-acid battery B acquired by the first current value acquisition unit 131 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state. The first threshold for the discharge determination is set by the setting unit 14 and recorded in the recording unit 12, and the discharge determination unit 132 acquires information regarding the first threshold from the recording unit 12.

In a case where it is determined by the discharge determination unit 132 that the lead-acid battery B is in the discharge (n-th discharge Dn) state, the discharge current value integration unit 133 integrates discharge current values from the start of the discharge of the lead-acid battery B, and calculates an integrated discharge capacity value from the start of the discharge of the lead-acid battery B.

The second current value acquisition unit 134 acquires, from the recording unit 12, information regarding the current value of the lead-acid battery B input to the recording unit 12 via the measurement unit 11 from the start to the end of the processing in the state determination unit 13.

In addition, the charge/discharge determination unit 135 determines whether the lead-acid battery B is in the discharge state, the stop state, or the charge state based on the current value of the lead-acid battery B acquired by the second current value acquisition unit 134.

Here, in a case where the current value of the lead-acid battery B acquired by the second current value acquisition unit 134 is smaller than the first threshold (the current value < the first threshold), the charge/discharge determination unit 135 determines that the lead-acid battery B is in the discharge (n-th discharge Dn) state,

in a case where the first threshold ≤ the current value ≤ the second threshold, the charge/discharge determination unit 135 determines that the lead-acid battery B is in the stop state, and

in a case where the current value > the second threshold, the charge/discharge determination unit 135 determines that the lead-acid battery B is in the charge (n+1-th charge Cn+1) state.

The first threshold is the same value as the above-described first threshold, and the second threshold is a positive current value near 0 amperes.

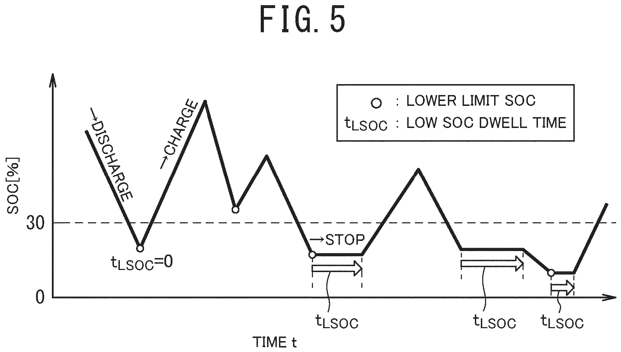

In a case where it is determined by the charge/discharge determination unit 135 that the lead-acid battery B is in the stop state, the low SOC dwell time calculation unit 136 determines whether or not an SOC at the corresponding time point is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 136 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above.

In addition, the lower limit SOC calculation unit 137 calculates the lower limit SOC which is the SOC having the smallest value when the lead-acid battery B is charged and discharged once, respectively. Specifically, in a case where the determination result of the charge/discharge determination unit 135 indicates that the lead-acid battery B is in the charge (n+1-th charge Cn+1) state, the lower limit SOC calculation unit 137 calculates $SOC_{end(n)}$ (see FIG. 3) after the end of the n-th discharge Dn of the lead-acid battery B to be subjected to calculation of the capacity turnover value during operation as the lower limit SOC. Here, the lower limit SOC calculation unit 137 acquires, from the recording unit 12, the rated capacity of the lead-acid battery B, the total charge amount of the lead-acid battery B from the completion of the equalization charge to an end time point of the n-th discharge Dn recorded in the recording unit 12 at the end of the n-th discharge Dn, and the total discharge amount (negative value) of the lead-acid battery B from the completion of the equalization charge to the end time point of the n-th discharge Dn recorded in the recording unit 12 at the end of the n-th discharge Dn. Then, the lower limit SOC calculation unit 137 calculates $SOC_{end(n)}$ by the following Formula (2) similar to Formula (1) described above.
[Mathematical Formula 2]

$$SOC_{end(n)} = \frac{(\text{Rated capacity} + \text{Total charge amount} + \text{Total discharge amount})}{\text{Rated capacity}} \times 100 \quad \cdots (2)$$

Next, after the lower limit SOC calculation unit 137 calculates the lower limit SOC, the capacity turnover value calculation unit 138 calculates the capacity turnover value during operation (hereinafter, referred to as the CT value during operation).

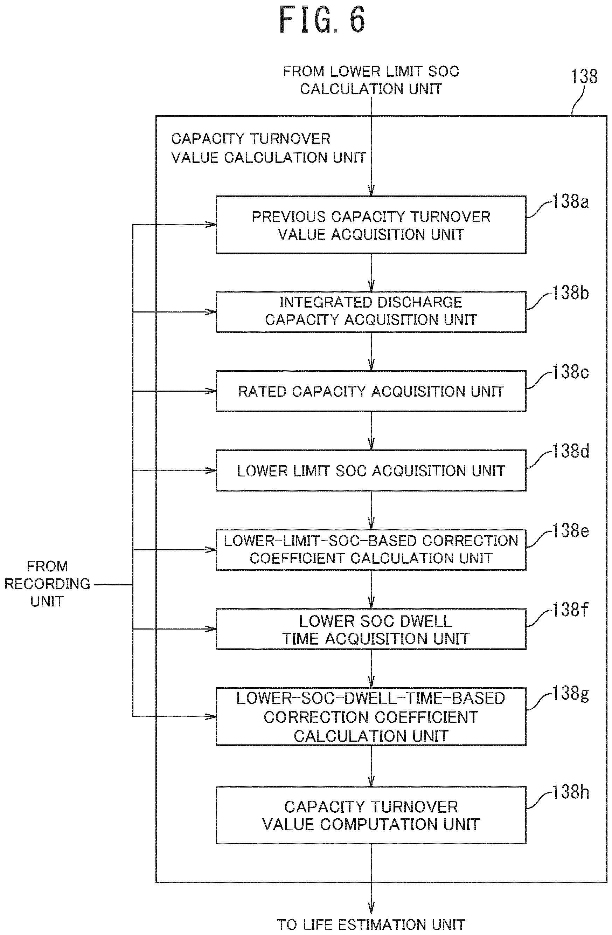

An internal configuration of the capacity turnover value calculation unit 138 will be described in more detail below. FIG. 6 is a block diagram illustrating an internal configuration of the capacity turnover value calculation unit 138 included in the state determination unit 13 illustrated in FIG. 4.

The capacity turnover value calculation unit 138 includes a previous capacity turnover value acquisition unit 138a, an integrated discharge capacity acquisition unit 138b, a rated capacity acquisition unit 138c, a lower limit SOC acquisition unit 138d, a lower-limit-SOC-based correction coefficient calculation unit 138e, a low SOC dwell time acquisition unit 138f, a low-SOC-dwell-time-based correction coefficient calculation unit 138g, and a capacity turnover value computation unit 138h.

In a case where the charge/discharge determination unit 135 determines that the lead-acid battery B is in the charge state, the previous capacity turnover value acquisition unit 138a acquires a capacity turnover value before the start of the processing in the state determination unit 13 (before the time point a1 in FIG. 3) (hereinafter, referred to as a previous CT value) from the recording unit 12. The previous CT value is a CT value during operation calculated by the capacity turnover value calculation unit 138 at the time of the previous processing in the state determination unit 13, and already input from the capacity turnover value calculation unit 138 to the recording unit 12.

In addition, the integrated discharge capacity acquisition unit 138b acquires information regarding the integrated discharge capacity value from the start of the discharge of the lead-acid battery B calculated by the discharge current value integration unit 133.

Further, the rated capacity acquisition unit 138c acquires information regarding the rated capacity (Ah) of the lead-acid battery B from the recording unit 12.

The lower limit SOC acquisition unit 138d acquires information regarding the lower limit SOC calculated by the lower limit SOC calculation unit 137.

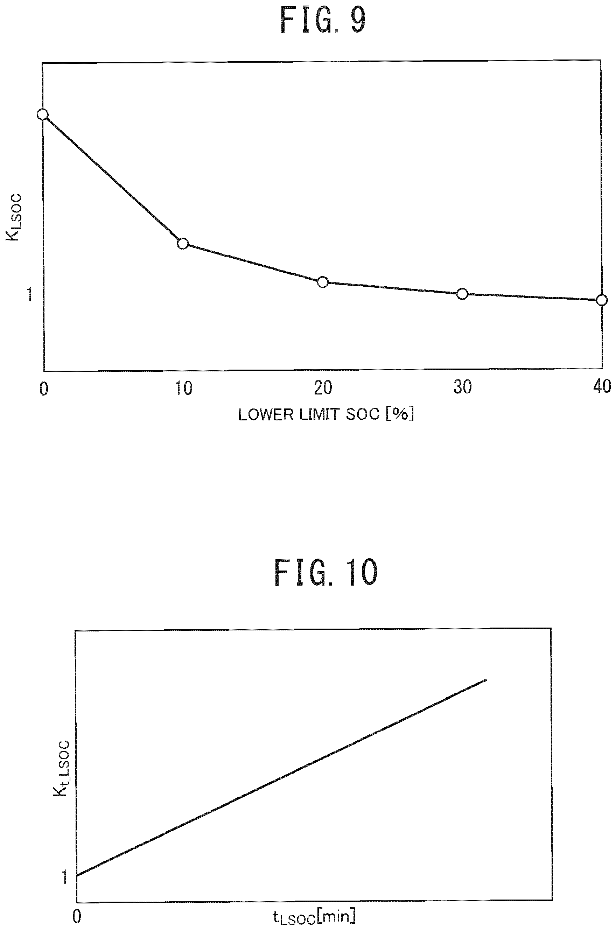

The lower-limit-SOC-based correction coefficient calculation unit 138e calculates the lower-limit-SOC-based correction coefficient $K_{LSOC}$ by using the lower limit SOC acquired by the lower limit SOC acquisition unit 138d. The lower-limit-SOC-based correction coefficient $K_{LSOC}$ is calculated with reference to a graph illustrating a relationship between the lower limit SOC and the lower-limit-SOC-based correction coefficient $K_{LSOC}$ illustrated in FIG. 9. Here, in FIG. 9, the lower-limit-SOC-based coefficient between the respective numerical values is calculated by creating an approximation curve from values of two adjacent points.

The low SOC dwell time acquisition unit 138f acquires information regarding the low SOC dwell time $t_{LSOC}$ calculated by the low SOC dwell time calculation unit 136.

The low-SOC-dwell-time-based correction coefficient calculation unit 138g calculates the low-SOC-dwell-time-based correction coefficient $K_{t\_LSOC}$ by using the low SOC dwell time $t_{LSOC}$ acquired by the low SOC dwell time acquisition unit 138f. The low-SOC-dwell-time-based correction coefficient $K_{t\_LSOC}$ is calculated with reference to a graph illustrating a relationship between the low SOC dwell time $t_{LSOC}$ and the low-SOC-dwell-time-based correction coefficient $K_{t\_LSOC}$ illustrated in FIG. 10. In the Ostwald ripening in which the SOC is predicted to be in the low SOC region (a region below the reference SOC (for example, 30% in the present embodiment)), a crystal volume increases in proportion to time, and the low-SOC-dwell-time-based correction coefficient $K_{t\_LSOC}$ increases in proportion to the low SOC dwell time $t_{LSOC}$.

Further, the capacity turnover value computation unit 138h calculates the CT value during operation by the following Formula (3) using the previous CT value acquired by the previous capacity turnover value acquisition unit 138a, the integrated discharge capacity from the start of the discharge of the lead-acid battery B acquired by the integrated discharge capacity acquisition unit 138b, the rated capacity (Ah) of the lead-acid battery B acquired by the rated capacity acquisition unit 183c, the lower-limit-SOC-based correction coefficient $K_{LSOC}$ calculated by the lower-limit-SOC-based correction coefficient calculation unit 138e, and the low-SOC-dwell-time-based correction coefficient $K_{t\_LSOC}$ calculated by the low-SOC-dwell-time-based correction coefficient calculation unit 138g.

[Mathematical Formula 3]

$$\text{CT value during operation} = \text{Previous CT value} + \frac{\text{Integrated discharge capacity}}{\text{Rated capacity(Ah)}} \times K_{LSOC} \times K_{t\_LSOC} \quad \cdots (3)$$

Then, the life estimation unit 139 of the state determination unit 13 estimates the remaining life of the lead-acid battery B by comparing the CT value from the beginning to the end of life acquired from the recording unit 12 with the CT value during operation calculated by the capacity turnover value calculation unit 138. That is, the life estimation unit 139 estimates the remaining life of the lead-acid battery B from a CT value obtained by subtracting the CT value during operation from the CT value from the beginning to the end of life.

Then, the life estimation unit 139 records an estimation result of the life estimation unit 139 including the CT value during operation in the recording unit 12. The life estimation unit 139 sets the low SOC dwell time $t_{LSOC}$ to 0 and records the low SOC dwell time $t_{LSOC}$ in the recording unit 12.

As described above, in the lead-acid battery system S according to the first embodiment, the capacity turnover value calculation unit 138 calculates the CT value during operation by using both the lower-limit-SOC-based correction coefficient $K_{LSOC}$ calculated based on the lower limit SOC calculated by the lower limit SOC calculation unit 137 that calculates the lower limit SOC which is the SOC having the smallest value when the lead-acid battery B is charged and discharged once, and the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC. As a result, it is possible to calculate the CT value during operation in consideration of both the lower limit SOC and the low SOC dwell time $T_{LSOC}$, to consider the progress of deterioration due to softening or sulfation of the active material, and to provide the lead-acid battery system S capable of accurately estimating the remaining life of the lead-acid battery B.

In the lead-acid battery system S according to the first embodiment, the lower limit SOC calculation unit 137 calculates $SOC_{end(n)}$ after the end of the discharge (n-th discharge Dn) of the lead-acid battery B to be subjected to calculation of the capacity turnover value during operation as the lower limit SOC, and the capacity turnover value calculation unit 138 calculates the lower-limit-SOC-based correction coefficient $K_{LSOC}$ calculated by the lower limit SOC calculation unit 137. As a result, the lower limit SOC can be determined and calculated after the end of the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery system S according to the first embodiment, in a case where the lead-acid battery B is a bipolar lead-acid battery, it is possible to provide the lead-acid battery system S capable of accurately estimating the remaining life of the bipolar lead-acid battery.

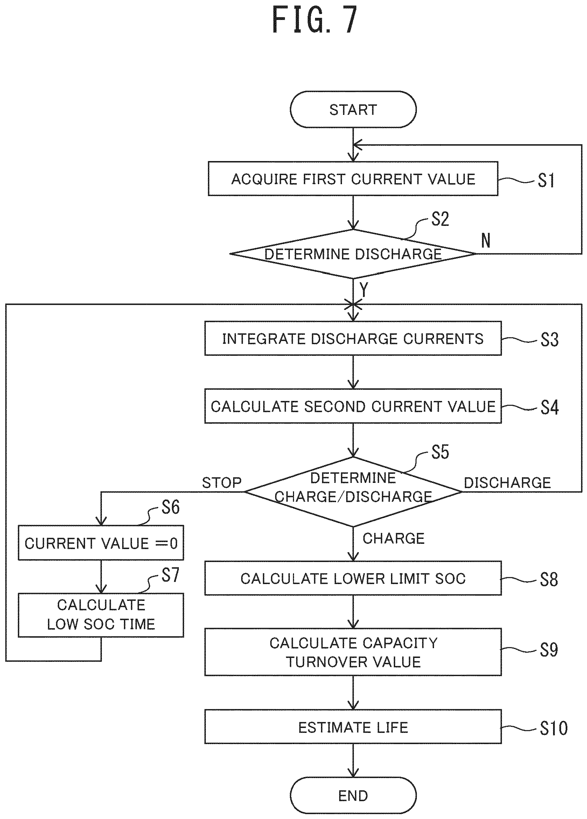

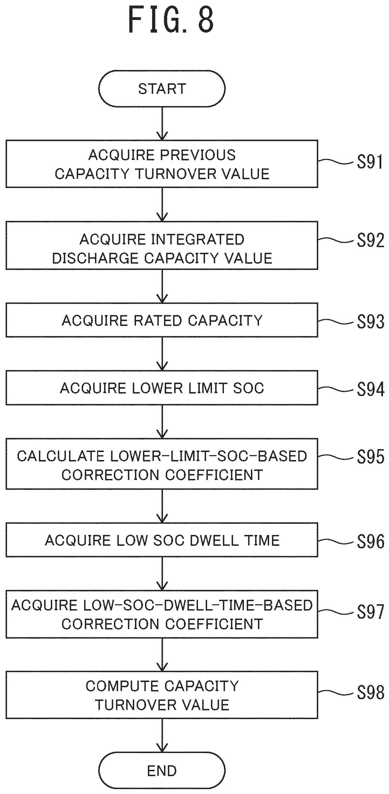

Next, a lead-acid battery life estimation method according to the first embodiment will be described with reference to a flowchart illustrating a flow of the processing in the state determination unit illustrated in FIG. 7 and a flowchart illustrating a flow of processing of step S9 (capacity turnover value calculation step) in the flowchart of FIG. 7 illustrated in FIG. 8.

The state determination unit 13 starts the processing from the time point a1 in FIG. 3. First, as illustrated in FIG. 7, in step S1, the first current value acquisition unit 131 of the state determination unit 13 acquires, from the recording unit 12, information regarding the current value of the lead-acid battery B input to the recording unit 12 via the measurement unit 11 from the start to the end (the time point b1 in FIG. 3) of the processing in the state determination unit 13 (first current value acquisition step).

Next, in step S2, the discharge determination unit 132 determines whether or not the lead-acid battery B is in the discharge state based on the current value of the lead-acid battery B acquired in step S1 (discharge determination step). Specifically, in a case where the current value of the lead-acid battery B acquired in step S1 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state. The first threshold for the discharge determination is set by the setting unit 14 and recorded in the recording unit 12, and the discharge determination unit 132 acquires information regarding the first threshold from the recording unit 12.

In a case where it is determined in step S2 that the lead-acid battery B is in the stop state or the charge state, the processing returns to step S1, and in a case where it is determined in step S2 that the lead-acid battery B is in the discharge state, the processing proceeds to step S3.

In step S3, the discharge current value integration unit 133 integrates the discharge current values from the start of the discharge of the lead-acid battery B, and calculates the integrated discharge capacity value from the start of the discharge of the lead-acid battery B (integrated discharge capacity value calculation step).

Next, in step S4, the second current value acquisition unit 134 acquires, from the recording unit 12, information regarding the current value of the lead-acid battery B input to the recording unit 12 via the measurement unit 11 from the start to the end of the processing in the state determination unit 13 (second current value acquisition step).

Next, in step S5, the charge/discharge determination unit 135 determines whether the lead-acid battery B is in the discharge state, the stop state, or the charge state based on the current value of the lead-acid battery B acquired in step S4 (charge/discharge determination step).

Here, in a case where the current value of the lead-acid battery B acquired in step S4 is smaller than the first threshold (the current value < the first threshold), the charge/discharge determination unit 135 determines that the lead-acid battery B is in the discharge (n-th discharge Dn) state,

in a case where the first threshold $\leq$ the current value $\leq$ the second threshold, the charge/discharge determination unit 135 determines that the lead-acid battery B is in the stop state, and
in a case where the current value > the second threshold, the charge/discharge determination unit 135 determines that the lead-acid battery B is in the charge (n+1-th charge Cn+1) state.

The first threshold is the same value as the above-described first threshold, and the second threshold is a positive current value near 0 amperes.

In a case where it is determined in step S5 that the lead-acid battery B is in the stop state, the low SOC dwell time calculation unit 136 sets the current value to 0 in step S6, and calculates the low SOC dwell time $t_{LSOC}$ in step S7 (low SOC dwell time calculation step). In step S7, the low SOC dwell time calculation unit 136 determines whether or not an SOC at a corresponding time point at which the determination result in step S5 indicates the stop state is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 136 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above. Then, after step S7, the processing returns to step S3.

In a case where the determination result in step S5 indicates the discharge state, the processing returns to step S3.

In a case where the determination result in step S5 indicates the charge (n+1-th charge Cn+1) state, in step S8, the lower limit SOC calculation unit 137 calculates the lower limit SOC which is the SOC having the smallest value when the lead-acid battery B is charged and discharged once, respectively. Specifically, the lower limit SOC calculation unit 137 calculates $SOC_{end(n)}$ (see FIG. 3) after the end of the n-th discharge Dn of the lead-acid battery B as the lower limit SOC (lower limit SOC calculation step). Here, as described above, the lower limit SOC calculation unit 137 acquires, from the recording unit 12, the rated capacity of the lead-acid battery B, the total charge amount of the lead-acid battery B from the completion of the equalization charge to an end time point of the n-th discharge Dn recorded in the recording unit 12 at the end of the n-th discharge Dn, and the total discharge amount (negative value) of the lead-acid battery B from the completion of the equalization charge to the end time point of the n-th discharge Dn recorded in the recording unit 12 at the end of the n-th discharge Dn. Then, the lower limit SOC calculation unit 137 calculates $SOC_{end(n)}$ by Formula (2) described above.

Next, in step S9, after calculating the lower limit SOC in step S8, the capacity turnover value calculation unit 138 calculates the capacity turnover value during operation (hereinafter, referred to as the CT value during operation) (capacity turnover value calculation step).

A detailed flow of processing in the capacity turnover value calculation unit 138 in step S9 will be described with reference to FIG. 8.

First, in step S91, the previous capacity turnover value acquisition unit 138a acquires, from the recording unit 12, a capacity turnover value before the start of the processing in the state determination unit 13 (before the time point a1 in FIG. 3) (hereinafter, referred to as a previous CT value) (previous CT value acquisition step). The previous CT value is a CT value during operation calculated in step S9 at the time of the previous processing in the state determination unit 13, and already input from the capacity turnover value calculation unit 138 to the recording unit 12.

Next, in step S92, the integrated discharge capacity acquisition unit 138b acquires information regarding the integrated discharge capacity value from the start of the discharge of the lead-acid battery B calculated in step S3 (integrated discharge capacity value acquisition step).

Next, in step S93, the rated capacity acquisition unit 138c acquires information regarding the rated capacity (Ah) of the lead-acid battery B from the recording unit 12 (rated capacity acquisition step).

Next, in step S94, the lower limit SOC acquisition unit 138d acquires information regarding the lower limit SOC calculated in step S8 (lower limit SOC acquisition step).

Next, in step S95, the lower-limit-SOC-based correction coefficient calculation unit 138e calculates the lower-limit-SOC-based correction coefficient $K_{LSOC}$ by using the lower limit SOC acquired in step S94 (lower-limit-SOC-based correction coefficient calculation step). As described above, the lower-limit-SOC-based correction coefficient $K_{LSOC}$ is calculated with reference to the graph illustrating the relationship between the lower limit SOC and the lower-limit-SOC-based correction coefficient $K_{LSOC}$ illustrated in FIG. 9.

Next, in step S96, the low SOC dwell time acquisition unit 138f acquires information regarding the low SOC dwell time $T_{LSOC}$ calculated in step S7 (low SOC dwell time acquisition step).

Next, in step S97, the low-SOC-dwell-time-based correction coefficient calculation unit 138g calculates the low-SOC-dwell-time-based correction coefficient $K_{t\_LSOC}$ by using the low SOC dwell time $t_{LSOC}$ acquired in step S96 (low-SOC-dwell-time-based correction coefficient calculation step). As described above, the low-SOC-dwell-time-based correction coefficient $K_{t\_LSOC}$ is calculated with reference to the graph illustrating the relationship between the low SOC dwell time $t_{LSOC}$ and the low-SOC-dwell-time-based correction coefficient $K_{t\_LSOC}$ illustrated in FIG. 10.

Then, in step S98, the capacity turnover value computation unit 138h calculates the CT value during operation by Formula (3) described above using the previous CT value acquired in step S91, the integrated discharge capacity from the start of the discharge of the lead-acid battery B acquired in step S92, the rated capacity (Ah) of the lead-acid battery B acquired in step S93, the lower-limit-SOC-based correction coefficient $K_{LSOC}$ calculated in step S95, and the low-SOC-dwell-time-based correction coefficient $K_{t\_LSOC}$ calculated in step S97 (capacity turnover value computation step).

As a result, the processing in the capacity turnover value calculation unit 138 in step S9 ends.

In step S10, the life estimation unit 139 of the state determination unit 13 estimates the remaining life of the lead-acid battery B by comparing the CT value from the beginning to the end of life acquired from the recording unit 12 with the CT value during operation calculated in step S9. That is, the life estimation unit 139 estimates the remaining life of the lead-acid battery B from a CT value obtained by subtracting the CT value during operation from the CT value from the beginning to the end of life.

Then, the life estimation unit 139 records an estimation result of the life estimation unit 139 including the CT value during operation in the recording unit 12. The life estimation unit 139 sets the low SOC dwell time $t_{LSOC}$ to 0 and records the low SOC dwell time $t_{LSOC}$ in the recording unit 12.

Accordingly, the processing in the state determination unit 13 ends.

As described above, in the lead-acid battery life estimation method according to the first embodiment, in the capacity turnover value calculation step (step S9), the CT value during operation is calculated using both the lower-limit-SOC-based correction coefficient $K_{LSOC}$ calculated based on the lower limit SOC calculated in the lower limit SOC calculation step (step S8) of calculating the lower limit SOC which is the SOC having the smallest value when the lead-acid battery B is charged and discharged once, respectively, and the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC. As a result, it is possible to calculate the CT value during operation in consideration of both the lower limit SOC and the low SOC dwell time $t_{LSOC}$, to consider the progress of deterioration due to softening or sulfation of the active material, and to provide the lead-acid battery system life estimation method capable of accurately estimating the remaining life of the lead-acid battery B.

In the lead-acid battery life estimation method according to the first embodiment, in the lower limit SOC calculation step (step S8), $SOC_{end(n)}$ after the end of the discharge (n-th discharge Dn) of the lead-acid battery B to be subjected to calculation of the capacity turnover value during operation is calculated as the lower limit SOC, and in the capacity turnover value calculation step (step S9), the lower-limit-SOC-based correction coefficient $K_{LSOC}$ is calculated based on the lower limit SOC calculated in the lower limit SOC calculation step (step S8). As a result, the lower limit SOC can be determined and calculated after the end of the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery life estimation method according to the first embodiment, in a case where the lead-acid battery B is a bipolar lead-acid battery, it is possible to provide a lead-acid battery life estimation method capable of accurately estimating the remaining life of the bipolar lead-acid battery.

(Second Embodiment)

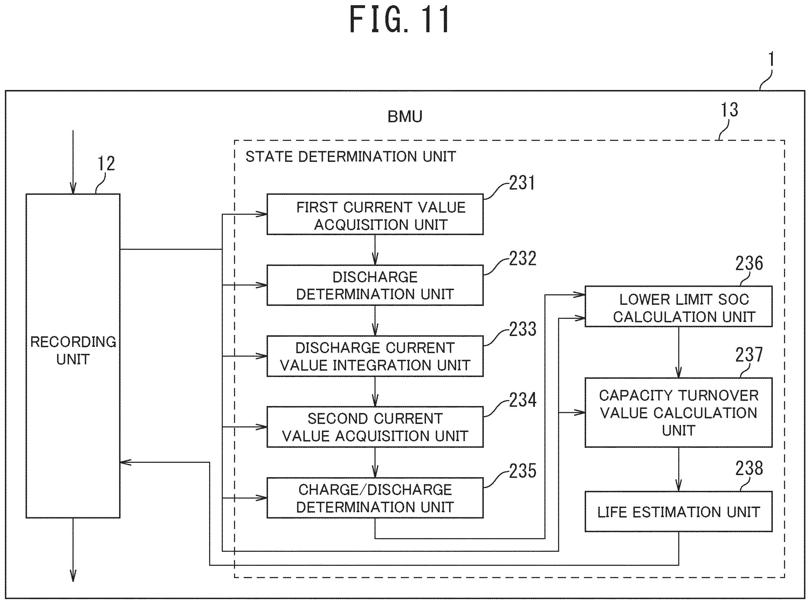

Next, the lead-acid battery system and a lead-acid battery life estimation method according to the second embodiment of the present invention will be described with reference to FIGS. 11 to 14. FIG. 11 is a block diagram illustrating internal configurations of a recording unit 12 and a state determination unit 13 included in the BMU 1 illustrated in FIG. 2 in the lead-acid battery system S according to the second embodiment of the present invention illustrated in FIG. 1.

The lead-acid battery system S according to the second embodiment has the same basic configuration as the lead-acid battery system S according to the first embodiment, and is different from the lead-acid battery system S according to the first embodiment in a configuration of the state determination unit 13.

The state determination unit 13 in the lead-acid battery system S according to the first embodiment calculates a lower limit SOC which is an SOC having the smallest value when a lead-acid battery B is charged and discharged once, respectively. Then, the state determination unit 13 calculates the capacity turnover value during operation by using both a lower-limit-SOC-based correction coefficient $K_{LSOC}$ calculated based on the calculated lower limit SOC and a low-SOC-dwell-time-based correction coefficient $K_{t\_LSOC}$ calculated based on a low SOC dwell time $t_{LSOC}$ which is an elapsed time until the next discharge or charge starts when a discharge ends below a reference SOC.

On the other hand, the state determination unit 13 in the lead-acid battery system S according to the second embodiment is different in that the lower limit SOC which is the SOC having the smallest value when the lead-acid battery B is charged and discharged once, respectively, is calculated, and the capacity turnover value during operation is calculated using only the lower-limit-SOC-based correction coefficient $K_{LSOC}$ calculated based on the calculated lower limit SOC.

Then, similarly to the state determination unit 13 of the first embodiment, as illustrated in FIG. 3, the state determination unit 13 of the second embodiment calculates $SOC_{end(n)}$ after the end of the discharge (n-th discharge Dn) of the lead-acid battery B to be subjected to calculation of a capacity turnover value during operation as the lower limit SOC. Therefore, unlike the state determination unit 13 in the lead-acid battery system S according to the first embodiment, the state determination unit 13 in the lead-acid battery system S according to the second embodiment does not include the low SOC dwell time calculation unit 136, and a capacity turnover value calculation unit 237 does not include the low SOC dwell time acquisition unit 138f and the low-SOC-dwell-time-based correction coefficient calculation unit 138g.

Similarly to the first embodiment, as illustrated in FIG. 3, the processing in the state determination unit 13 in the lead-acid battery system S according to the second embodiment is executed from a time point a1 at the time of the n-th charge Cn of the lead-acid battery B to a time point b1 after the end of the n-th discharge Dn, and the processing is repeated at the time of charging and discharging.

As illustrated in FIG. 11, the state determination unit 13 of the second embodiment includes a first current value acquisition unit 231, a discharge determination unit 232, a discharge current value integration unit 233, a second current value acquisition unit 234, a charge/discharge determination unit 235, a lower limit SOC calculation unit 236, a capacity turnover value calculation unit 237, and a life estimation unit 238 in order to estimate the remaining life of the lead-acid battery B.

The first current value acquisition unit 231 acquires, from the recording unit 12, information regarding a current value of the lead-acid battery B input to the recording unit 12 via a measurement unit 11 from the start to the end of the processing in the state determination unit 13.

In addition, the discharge determination unit 232 determines whether or not the lead-acid battery B is in a discharge state based on the current value of the lead-acid battery B acquired by the first current value acquisition unit 231. Specifically, in a case where the current value of the lead-acid battery B acquired by the first current value acquisition unit 231 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state.

In a case where the determination result of the discharge determination unit 232 indicates the discharge (n-th discharge Dn) state, the discharge current value integration unit 233 integrates discharge current values from the start of the discharge of the lead-acid battery B, and calculates an integrated discharge capacity value from the start of the discharge of the lead-acid battery B.

The second current value acquisition unit 234 acquires, from the recording unit 12, information regarding the current value of the lead-acid battery B input to the recording unit 12 via the measurement unit 11 from the start to the end of the processing in the state determination unit 13.

In addition, the charge/discharge determination unit 235 determines whether the lead-acid battery B is in the discharge state, the stop state, or the charge state based on the current value of the lead-acid battery B acquired by the second current value acquisition unit 234.

Here, in a case where the current value of the lead-acid battery B acquired by the second current value acquisition unit 234 is smaller than the first threshold (the current value < the first threshold), the charge/discharge determination unit 135 determines that the lead-acid battery B is in the discharge (n-th discharge Dn) state,

in a case where the first threshold ≤ the current value ≤ a second threshold, the charge/discharge determination unit 235 determines that the lead-acid battery B is in the stop state, and
in a case where the current value > the second threshold, the charge/discharge determination unit 235 determines that the lead-acid battery B is in the charge (n+1-th charge Cn+1) state.

The first threshold and the second threshold are the same as those in the first embodiment.

In addition, the lower limit SOC calculation unit 236 calculates the lower limit SOC which is the SOC having the smallest value when the lead-acid battery B is charged and discharged once, respectively. Specifically, in a case where it is determined by the charge/discharge determination unit 235 that the lead-acid battery B is in the charge (n+1-th charge Cn+1) state, the lower limit SOC calculation unit 236 calculates $SOC_{end(n)}$ (see FIG. 3) after the end of the n-th discharge Dn of the lead-acid battery B to be subjected to calculation of the capacity turnover value during operation as the lower limit SOC. Here, the lower limit SOC calculation unit 236 acquires, from the recording unit 12, the total charge amount of the lead-acid battery B from completion of an equalization charge to an end time point of the n-th discharge Dn, and the total discharge amount (negative value) of the lead-acid battery B from the completion of the equalization charge to the end time point of the n-th discharge Dn recorded in the recording unit 12 at the end of the n-th discharge Dn, and calculates $SOC_{end(n)}$ by Formula (2) described above.

Next, after the lower limit SOC calculation unit 236 calculates the lower limit SOC, the capacity turnover value calculation unit 237 calculates the capacity turnover value during operation (hereinafter, referred to as the CT value during operation).

An internal configuration of the capacity turnover value calculation unit 237 will be described in more detail below.

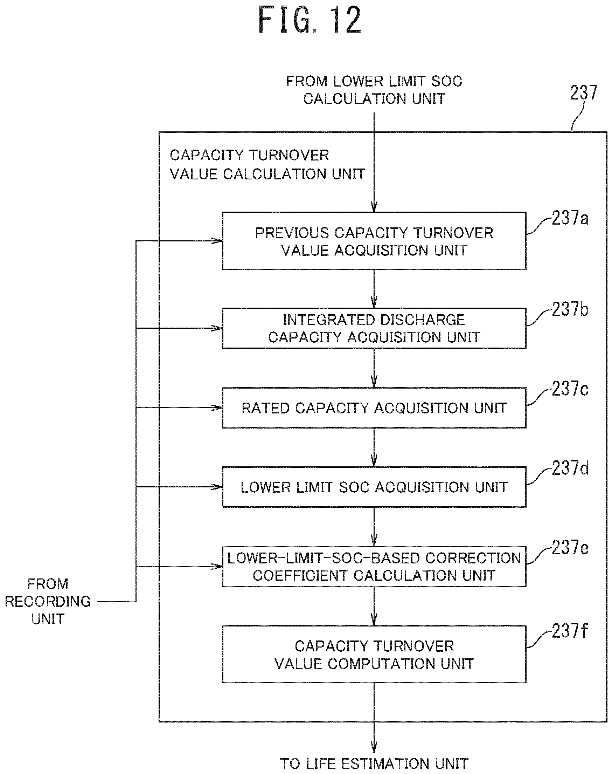

FIG. 12 is a block diagram illustrating an internal configuration of the capacity turnover value calculation unit 237 included in the state determination unit 13 illustrated in FIG. 11.

The capacity turnover value calculation unit 237 includes a previous capacity turnover value acquisition unit 237a, an integrated discharge capacity acquisition unit 237b, a rated capacity acquisition unit 237c, a lower limit SOC acquisition unit 237d, a lower-limit-SOC-based correction coefficient calculation unit 237e, and a capacity turnover value computation unit 237f.

The previous capacity turnover value acquisition unit 237a acquires, from the recording unit 12, a capacity turnover value before the start of the processing in the state determination unit 13 (before the time point a1 in FIG. 3) (hereinafter, referred to as a previous CT value). The previous CT value is a CT value during operation calculated by the capacity turnover value calculation unit 237 at the time of the previous processing in the state determination unit 13, and already input from the capacity turnover value calculation unit 237 to the recording unit 12.

In addition, the integrated discharge capacity acquisition unit 237b acquires information regarding the integrated discharge capacity value from the start of the discharge of the lead-acid battery B calculated by the discharge current value integration unit 233.

Further, the rated capacity acquisition unit 237c acquires information regarding the rated capacity (Ah) of the lead-acid battery B from the recording unit 12.

The lower limit SOC acquisition unit 237d acquires information regarding the lower limit SOC calculated by the lower limit SOC calculation unit 236.

The lower-limit-SOC-based correction coefficient calculation unit 237e calculates the lower-limit-SOC-based correction coefficient $K_{LSOC}$ by using the lower limit SOC acquired by the lower limit SOC acquisition unit 237d. Similarly to the first embodiment, the lower-limit-SOC-based correction coefficient $K_{LSOC}$ is calculated with reference to the graph illustrating the relationship between the lower limit SOC and the lower-limit-SOC-based correction coefficient $K_{LSOC}$ illustrated in FIG. 9.

Further, the capacity turnover value computation unit 237f calculates the CT value during operation by the following Formula (4) using the previous CT value acquired by the previous capacity turnover value acquisition unit 237a, the integrated discharge capacity from the start of the discharge of the lead-acid battery B acquired by the integrated discharge capacity acquisition unit 237b, the rated capacity (Ah) of the lead-acid battery B acquired by the rated capacity acquisition unit 237c, and the upper-limit-SOC-based correction coefficient $K_{LSOC}$ calculated by the upper-limit-SOC-based correction coefficient calculation unit 237e.

[Mathematical Formula 4]

$$\text{CT value during operation} = \text{Previous CT value} + \frac{\text{Integrated discharge capacity}}{\text{Rated capacity(Ah)}} \times K_{LSOC}$$

$$\cdots (4)$$

Then, the life estimation unit 238 of the state determination unit 13 estimates the remaining life of the lead-acid battery B by comparing the CT value from the beginning to the end of life acquired from the recording unit 12 with the CT value during operation calculated by the capacity turnover value calculation unit 237. That is, the life estimation unit 238 estimates the remaining life of the lead-acid battery B from a CT value obtained by subtracting the CT value during operation from the CT value from the beginning to the end of life.

Then, the life estimation unit 238 records an estimation result of the life estimation unit 238 including the CT value during operation in the recording unit 12.

As described above, in the lead-acid battery system S according to the second embodiment, the capacity turnover value calculation unit 237 calculates the CT value during operation by using the lower-limit-SOC-based correction coefficient $K_{LSOC}$ calculated based on the lower limit SOC calculated by the lower limit SOC calculation unit 236 that calculates the lower limit SOC which is the SOC having the smallest value when the lead-acid battery B is charged and discharged once, respectively. As a result, it is possible to calculate the CT value during operation in consideration of the lower limit SOC, to consider the progress of deterioration due to softening or sulfation of the active material, and to provide the lead-acid battery system S capable of accurately estimating the remaining life of the lead-acid battery B.

In the lead-acid battery system S according to the second embodiment, the lower limit SOC calculation unit 236 calculates $SOC_{end(n)}$ after the end of the discharge (n-th discharge Dn) of the lead-acid battery B to be subjected to calculation of the capacity turnover value during operation as the lower limit SOC, and the capacity turnover value calculation unit 237 calculates the lower-limit-SOC-based correction coefficient $K_{LSOC}$ based on the lower limit SOC calculated by the lower limit SOC calculation unit 236. As a result, the lower limit SOC can be determined and calculated after the end of the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery system S according to the second embodiment, in a case where the lead-acid battery B is a bipolar lead-acid battery, it is possible to provide the lead-acid battery system S capable of accurately estimating the remaining life of the bipolar lead-acid battery.

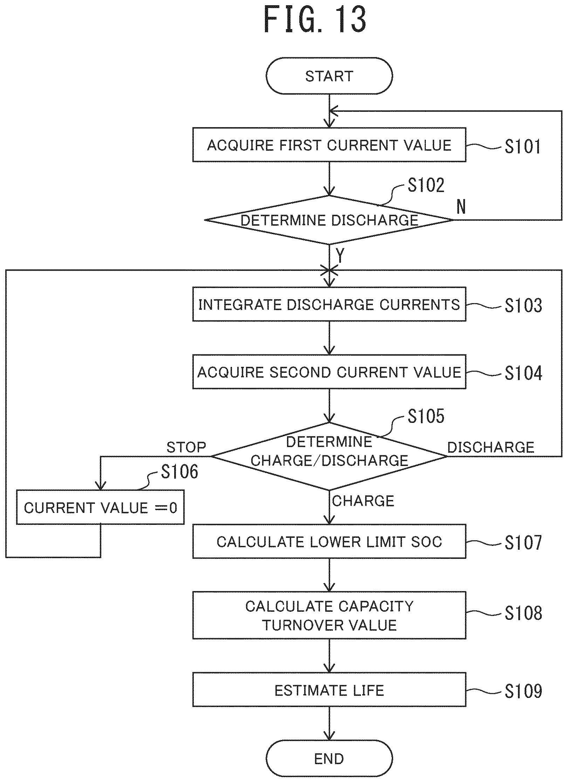

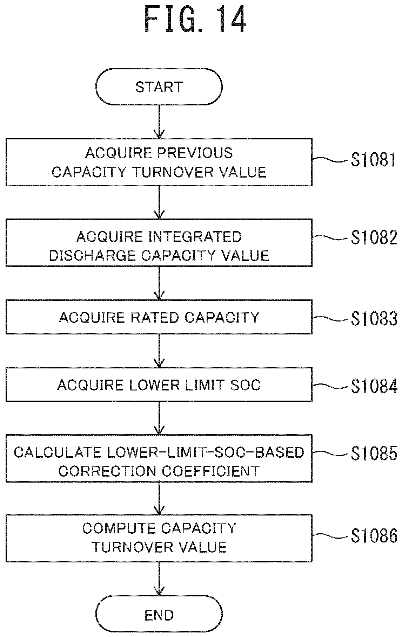

Next, the lead-acid battery life estimation method according to the second embodiment will be described with reference to a flowchart illustrating a flow of the processing in the state determination unit illustrated in FIG. 13 and a flowchart illustrating a flow of processing of step S108 (capacity turnover value calculation step) in the flowchart of FIG. 13 illustrated in FIG. 14.

The state determination unit 13 starts the processing from the time point a1 in FIG. 3. First, as illustrated in FIG. 13, in step S101, the first current value acquisition unit 231 of the state determination unit 13 acquires, from the recording unit 12, information regarding the current value of the lead-acid battery B input to the recording unit 12 via the measurement unit 11 from the start to the end (the time point b1 in FIG. 3) of the processing in the state determination unit 13 (first current value acquisition step).

Next, in step S102, the discharge determination unit 232 determines whether or not the lead-acid battery B is in the discharge state based on the current value of the lead-acid battery B acquired in step S101 (discharge determination step). Specifically, in a case where the current value of the lead-acid battery B acquired in step S101 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state.

In a case where it is determined in step S102 that the lead-acid battery B is in the stop state or the charge (n-th charge Cn) state, the processing returns to step S101, and in a case where it is determined in step S102 that the lead-acid battery B is in the discharge (n-th discharge Dn) state, the processing proceeds to step S103.

In step S103, the discharge current value integration unit 233 integrates the discharge current values from the start of the discharge of the lead-acid battery B, and calculates the integrated discharge capacity value from the start of the discharge of the lead-acid battery B (integrated discharge capacity value calculation step).

Next, in step S104, the second current value acquisition unit 134 acquires, from the recording unit 12, information regarding the current value of the lead-acid battery B input to the recording unit 12 via the measurement unit 11 from the start to the end of the processing in the state determination unit 13 (second current value acquisition step).

Next, in step S105, the charge/discharge determination unit 235 determines whether the lead-acid battery B is in the discharge state, the stop state, or the charge state based on the current value of the lead-acid battery B acquired in step S104 (charge/discharge determination step).

Here, in a case where the current value of the lead-acid battery B acquired in step S104 is smaller than the first threshold (the current value < the first threshold), the charge/discharge determination unit 235 determines that the lead-acid battery B is in the discharge (n-th discharge Dn) state,

in a case where the first threshold ≤ the current value ≤ the second threshold, the charge/discharge determination unit 235 determines that the lead-acid battery B is in the stop state, and

in a case where the current value > the second threshold, the charge/discharge determination unit 235 determines that the lead-acid battery B is in the charge (n+1-th charge Cn+1) state.

The first threshold is the same value as the above-described first threshold, and the second threshold is a positive current value near 0 amperes.

In a case where the determination result in step S105 indicates the stop state, the current value is set to 0 in step S106, and the processing returns to step S103. In a case where the determination result in step S105 indicates the discharge (n-th discharge Dn) state, the processing returns to step S103. In a case where the determination result in step S105 indicates the charge (n+1-th charge Cn+1) state, the processing proceeds to step S107.

In step S107, the lower limit SOC calculation unit 236 calculates the lower limit SOC which is the SOC having the smallest value when the lead-acid battery B is charged and discharged once, respectively. Specifically, the lower limit SOC calculation unit 236 calculates $SOC_{end(n)}$ (see FIG. 3) after the end of the n-th discharge Dn of the lead-acid battery B to be subjected to calculation of the capacity turnaround value during operation as the lower limit SOC (lower limit SOC calculation step). Here, the lower limit SOC calculation unit 236 acquires, from the recording unit 12, the total charge amount of the lead-acid battery B from completion of an equalization charge to an end time point of the n-th discharge Dn, and the total discharge amount (negative value) of the lead-acid battery B from the completion of the equalization charge to the end time point of the n-th discharge Dn recorded in the recording unit 12 at the end of the n-th discharge Dn, and calculates $SOC_{end(n)}$ by Formula (2) described above.

Next, in step S108, after calculating the lower limit SOC in step S107, the capacity turnover value calculation unit 237 calculates the capacity turnover value during operation (hereinafter, referred to as the CT value during operation) (capacity turnover value calculation step).

A detailed flow of processing in the capacity turnover value calculation unit 237 in step S108 will be described with reference to FIG. 14.

First, in step S1081, the previous capacity turnover value acquisition unit 237a acquires, from the recording unit 12, a capacity turnover value before the start of the processing in the state determination unit 13 (before the time point a1 in FIG. 3) (hereinafter, referred to as a previous CT value) (previous CT value acquisition step). The previous CT value is a CT value during operation calculated in step S108 at the time of the previous processing in the state determination unit 13, and already input from the capacity turnover value calculation unit 237 to the recording unit 12.

Next, in step S1082, the integrated discharge capacity acquisition unit 237b acquires information regarding the integrated discharge capacity value from the start of the discharge of the lead-acid battery B calculated in step S103 (integrated discharge capacity value acquisition step).

Next, in step S1083, the rated capacity acquisition unit 138c acquires information regarding the rated capacity (Ah) of the lead-acid battery B from the recording unit 12 (rated capacity acquisition step).

Next, in step S1084, the lower limit SOC acquisition unit 237d acquires information regarding the lower limit SOC calculated in step S107 (lower limit SOC acquisition step).

Next, in step S1085, the lower-limit-SOC-based correction coefficient calculation unit 237e calculates the lower-limit-SOC-based correction coefficient $K_{LSOC}$ by using the lower limit SOC acquired in step S1084 (lower-limit-SOC-based correction coefficient calculation step). As described above, the lower-limit-SOC-based correction coefficient $K_{LSOC}$ is calculated with reference to the graph illustrating the relationship between the lower limit SOC and the lower-limit-SOC-based correction coefficient $K_{LSOC}$ illustrated in FIG. 9.

In step S1086, the capacity turnover value computation unit 237f calculates the CT value during operation by Formula (4) using the previous CT value acquired in step S1081, the integrated discharge capacity from the start of the discharge of the lead-acid battery B acquired in step S1082, the rated capacity (Ah) of the lead-acid battery B acquired in step S1083, and the lower-limit-SOC-based correction coefficient $K_{LSOC}$ calculated in step S1085 (capacity turnover value computation step).

As a result, the processing in the capacity turnover value calculation unit 237 in step S108 ends.

In step S109, the life estimation unit 238 of the state determination unit 13 estimates the remaining life of the lead-acid battery B by comparing the CT value from the beginning to the end of life acquired from the recording unit 12 with the CT value during operation calculated in step S108. That is, the life estimation unit 238 estimates the remaining life of the lead-acid battery B from a CT value obtained by subtracting the CT value during operation from the CT value from the beginning to the end of life.

Then, the life estimation unit 239 records an estimation result of the life estimation unit 239 including the CT value during operation in the recording unit 12.

Accordingly, the processing in the state determination unit 13 ends.

As described above, in the lead-acid battery life estimation method according to the second embodiment, in the capacity turnover value calculation step (step S108), the CT value during operation is calculated using the lower-limit-SOC-based correction coefficient $K_{LSOC}$ calculated based on the lower limit SOC calculated in the lower limit SOC calculation step (step S107) of calculating the lower limit SOC which is the SOC having the smallest value when the lead-acid battery B is charged and discharged once, respectively. As a result, it is possible to calculate the CT value during operation in consideration of the lower limit SOC, to consider the progress of deterioration due to softening or sulfation of the active material, and to provide the lead-acid battery system life estimation method capable of accurately estimating the remaining life of the lead-acid battery B.

In the lead-acid battery life estimation method according to the second embodiment, in the lower limit SOC calculation step (step S107), $SOC_{end(n)}$ after the end of the discharge (n-th discharge Dn) of the lead-acid battery B to be subjected to calculation of the capacity turnover value during operation is calculated as the lower limit SOC, and in the capacity turnover value calculation step (step S108), the lower-limit-SOC-based correction coefficient $K_{LSOC}$ is calculated based on the lower limit SOC calculated in the lower limit SOC calculation step (step S8). As a result, the lower limit SOC can be determined and calculated after the end of the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery life estimation method according to the second embodiment, in a case where the lead-acid battery B is a bipolar lead-acid battery, it is possible to provide a lead-acid battery life estimation method capable of accurately estimating the remaining life of the bipolar lead-acid battery.

(Third Embodiment)

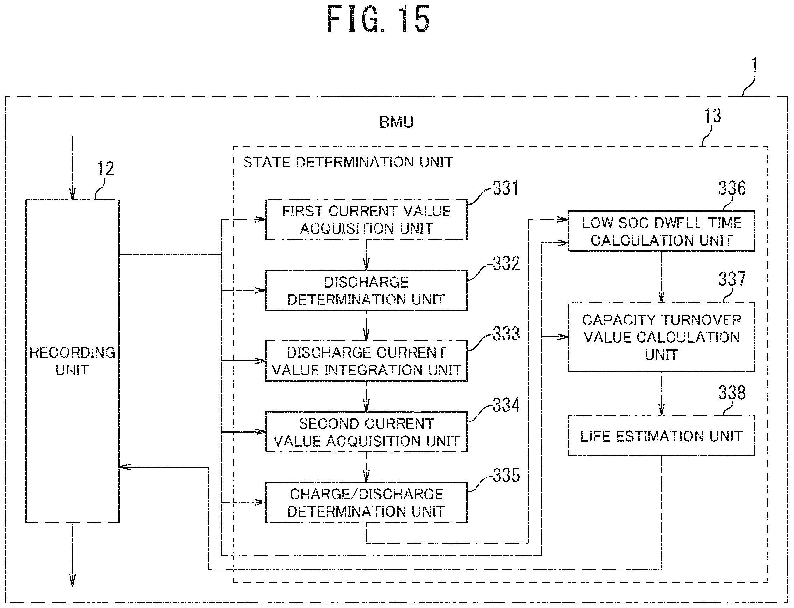

Next, the lead-acid battery system and a lead-acid battery life estimation method according to the third embodiment of the present invention will be described with reference to FIGS. 15 to 18. FIG. 15 is a block diagram illustrating internal configurations of a recording unit 12 and a state determination unit 13 included in the BMU 1 illustrated in FIG. 2 in the lead-acid battery system S according to the third embodiment of the present invention illustrated in FIG. 1.

The lead-acid battery system S according to the third embodiment has the same basic configuration as the lead-acid battery system S according to the first embodiment, and is different from the lead-acid battery system S according to the first embodiment in a configuration of a state determination unit 13.

The state determination unit 13 in the lead-acid battery system S according to the first embodiment calculates a lower limit SOC which is an SOC having the smallest value when the lead-acid battery B is charged and discharged once, respectively, and calculates a capacity turnover value during operation by using both a lower-limit-SOC-based correction coefficient $K_{LSOC}$ calculated based on the calculated lower limit SOC and a low-SOC-dwell-time-based correction coefficient $K_{t\_LSOC}$ calculated based on a low SOC dwell time $t_{LSOC}$ which is an elapsed time until the next discharge or charge starts when a discharge ends below a reference SOC.

On the other hand, the state determination unit 13 in the lead-acid battery system S according to the third embodiment is different in that the capacity turnover value during operation is calculated using only the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC.

Therefore, unlike the state determination unit 13 in the lead-acid battery system S according to the first embodiment, the state determination unit 13 in the lead-acid battery system S according to the third embodiment does not include the lower limit SOC calculation unit 137, and a capacity turnover value calculation unit 337 does not include the lower limit SOC acquisition unit 138d and the lower-limit-SOC-based correction coefficient calculation unit 138e.

Similarly to the first embodiment, as illustrated in FIG. 3, the processing in the state determination unit 13 in the lead-acid battery system S according to the third embodiment is executed from a time point a1 at the time of the n-th charge Cn of the lead-acid battery B to a time point b1 after the end of the n-th discharge Dn, and the processing is repeated at the time of charging and discharging.

As illustrated in FIG. 15, the state determination unit 13 of the third embodiment includes a first current value acquisition unit 331, a discharge determination unit 332, a discharge current value integration unit 333, a second current value acquisition unit 334, a charge/discharge determination unit 335, a low SOC dwell time calculation unit 336, a capacity turnover value calculation unit 337, and a life estimation unit 338 in order to estimate the remaining life of the lead-acid battery B.

The first current value acquisition unit 331 acquires, from the recording unit 12, information regarding a current value of the lead-acid battery B input to the recording unit 12 via a measurement unit 11 from the start to the end of the processing in the state determination unit 13.

In addition, the discharge determination unit 332 determines whether or not the lead-acid battery B is in a discharge state based on the current value of the lead-acid battery B acquired by the first current value acquisition unit 331. Specifically, in a case where the current value of the lead-acid battery B acquired by the first current value acquisition unit 331 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state.

In a case where the determination result of the discharge determination unit 332 indicates the discharge (n-th discharge Dn) state, the discharge current value integration unit 333 integrates discharge current values from the start of the discharge of the lead-acid battery B, and calculates an integrated discharge capacity value from the start of the discharge of the lead-acid battery B.

The second current value acquisition unit 334 acquires, from the recording unit 12, information regarding the current value of the lead-acid battery B input to the recording unit 12 via the measurement unit 11 from the start to the end of the processing in the state determination unit 13.

In addition, the charge/discharge determination unit 235 determines whether the lead-acid battery B is in the discharge state, the stop state, or the charge state based on the current value of the lead-acid battery B acquired by the second current value acquisition unit 334.

Here, in a case where the current value of the lead-acid battery B acquired by the second current value acquisition unit 334 is smaller than the first threshold (the current value < the first threshold), the charge/discharge determination unit 335 determines that the lead-acid battery B is in the discharge (n-th discharge Dn) state,

in a case where the first threshold ≤ the current value ≤ a second threshold, the charge/discharge determination unit 235 determines that the lead-acid battery B is in the stop state, and
in a case where the current value > the second threshold, the charge/discharge determination unit 335 determines that the lead-acid battery B is in the charge (n+1-th charge Cn+1) state.

The first threshold and the second threshold are the same as those in the first embodiment.

In a case where it is determined by the charge/discharge determination unit 335 that the lead-acid battery B is in the stop state, the low SOC dwell time calculation unit 336 determines whether or not an SOC at the corresponding time point is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 336 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above.

Next, in a case where it is determined by the charge/discharge determination unit 235 that the lead-acid battery B is in the charge (n+1-th charge Cn+1) state, the capacity turnover value calculation unit 337 calculates the capacity turnover value during operation (hereinafter, referred to as the CT value during operation).

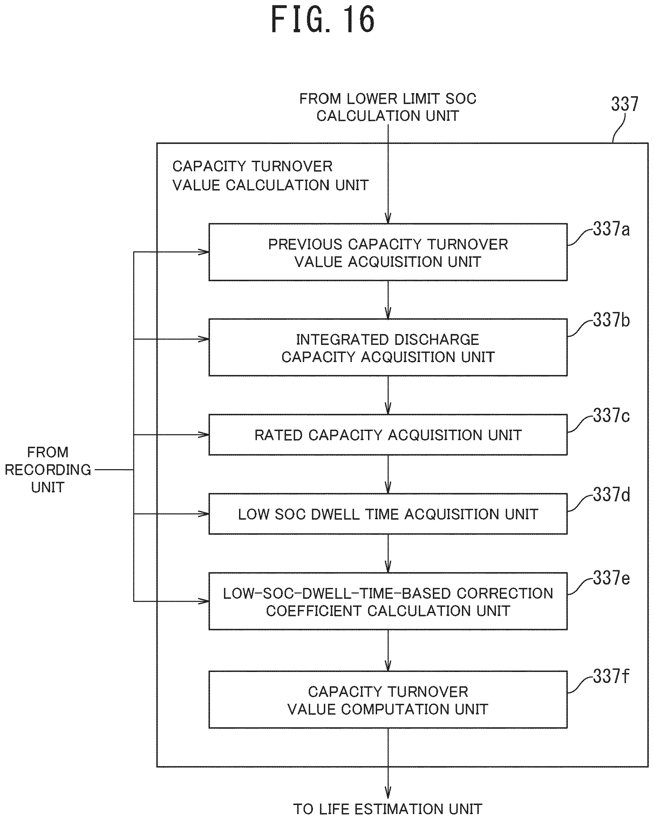

An internal configuration of the capacity turnover value calculation unit 337 will be described in more detail below. FIG. 16 is a block diagram illustrating an internal configuration of the capacity turnover value calculation unit 337 included in the state determination unit 13 illustrated in FIG. 15.

The capacity turnover value calculation unit 337 includes a previous capacity turnover value acquisition unit 337a, an integrated discharge capacity acquisition unit 337b, a rated capacity acquisition unit 337c, a low SOC dwell time acquisition unit 337d, a low-SOC-dwell-time-based correction coefficient calculation unit 337e, and a capacity turnover value computation unit 337f.

The previous capacity turnover value acquisition unit 337a acquires, from the recording unit 12, a capacity turnover value before the start of the processing in the state determination unit 13 (before the time point a1 in FIG. 3) (hereinafter, referred to as a previous CT value). The previous CT value is a CT value during operation calculated by the capacity turnover value calculation unit 337 at the time of the previous processing in the state determination unit 13, and already input from the capacity turnover value calculation unit 337 to the recording unit 12.

In addition, the integrated discharge capacity acquisition unit 337b acquires information regarding the integrated discharge capacity value from the start of the discharge of the lead-acid battery B calculated by the discharge current value integration unit 333.

Further, the rated capacity acquisition unit 337c acquires information regarding the rated capacity (Ah) of the lead-acid battery B from the recording unit 12.

The low SOC dwell time acquisition unit 337d acquires information regarding the low SOC dwell time $t_{LSOC}$ calculated by the low SOC dwell time calculation unit 336.

The low-SOC-dwell-time-based correction coefficient calculation unit 337e calculates the low-SOC-dwell-time-based correction coefficient $K_{t\_LSOC}$ by using the low SOC dwell time $t_{LSOC}$ acquired by the low SOC dwell time acquisition unit 337d. Similarly to the first embodiment, the low-SOC-dwell-time-based correction coefficient $K_{t\_LSOC}$ is calculated with reference to the graph illustrating the relationship between the low SOC dwell time $t_{LSOC}$ and the low-SOC-dwell-time-based correction coefficient $K_{t\_LSOC}$ illustrated in FIG. 10.

Furthermore, the capacity turnover value computation unit 337f calculates the CT value during operation by the following Formula (5) using the previous CT value acquired by the previous capacity turnover value acquisition unit 337a, the integrated discharge capacity from the start of the discharge of the lead-acid battery B acquired by the integrated discharge capacity acquisition unit 337b, the rated capacity (Ah) of the lead-acid battery B acquired by the rated capacity acquisition unit 337c, and the low-SOC-dwell-time-based correction coefficient $K_{t\_LSOC}$ calculated by the low-SOC-dwell-time-based correction coefficient calculation unit 337e.

[Mathematical Formula 5]

$$\text{CT value during operation} = \text{Previous CT value} + \frac{\text{Integrated discharge capacity}}{\text{Rated capacity(Ah)}} \times K_{t\_LSOC}$$

$$\cdots (5)$$

Then, the life estimation unit 338 of the state determination unit 13 estimates the remaining life of the lead-acid battery B by comparing the CT value from the beginning to the end of life acquired from the recording unit 12 with the CT value during operation calculated by the capacity turnover value calculation unit 337. That is, the life estimation unit 338 estimates the remaining life of the lead-acid battery B from a CT value obtained by subtracting the CT value during operation from the CT value from the beginning to the end of life.

Then, the life estimation unit 338 records an estimation result of the life estimation unit 338 including the CT value during operation in the recording unit 12. The life estimation unit 338 sets the low SOC dwell time $t_{LSOC}$ to 0 and records the low SOC dwell time $t_{LSOC}$ in the recording unit 12.

As described above, in the lead-acid battery system S according to the third embodiment, the capacity turnover value calculation unit 337 calculates the capacity turnover value during operation by using the low-SOC-dwell-time-based correction coefficient $K_{t\_LSOC}$ calculated based on the low SOC dwell time $t_{LSOC}$ which is the elapsed time until the start of the next discharge or charge when a discharge ends below the reference SOC. As a result, it is possible to calculate the capacity turnover value during operation in consideration of the low SOC dwell time, to consider the progress of deterioration due to softening or sulfation of the active material, and to provide the lead-acid battery system S capable of accurately estimating the remaining life of the lead-acid battery.

In the lead-acid battery system S according to the third embodiment, in a case where the lead-acid battery B is a bipolar lead-acid battery, it is possible to provide the lead-acid battery system S capable of accurately estimating the remaining life of the bipolar lead-acid battery.

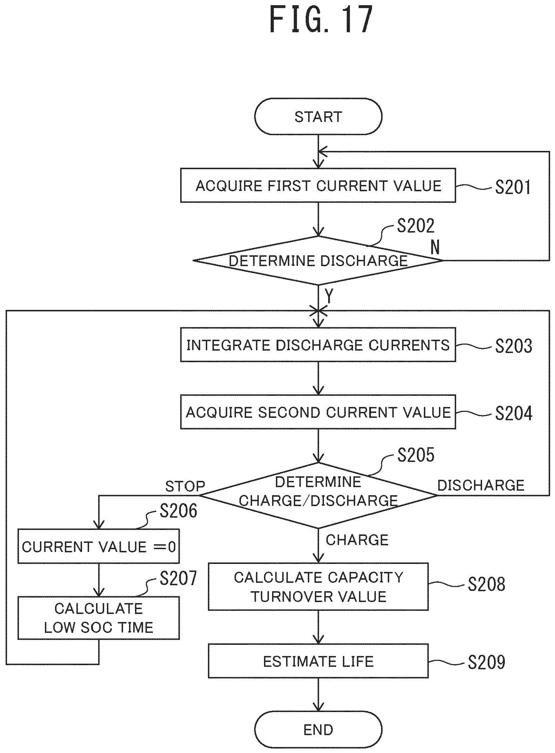

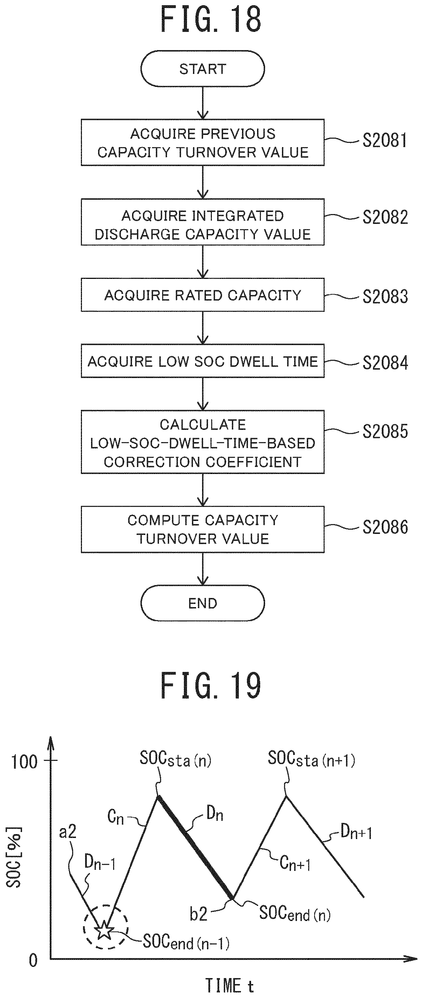

Next, the lead-acid battery life estimation method according to the third embodiment will be described with reference to a flowchart illustrating a flow of the processing in the state determination unit illustrated in FIG. 17 and a flowchart illustrating a flow of processing of step S208 (capacity turnover value calculation step) in the flowchart of FIG. 17 illustrated in FIG. 18.

The state determination unit 13 starts the processing from the time point a1 in FIG. 3. First, as illustrated in FIG. 17, in step S201, the first current value acquisition unit 331 of the state determination unit 13 acquires, from the recording unit 12, information regarding the current value of the lead-acid battery B input to the recording unit 12 via the measurement unit 11 from the start to the end (the time point b1 in FIG. 3) of the processing in the state determination unit 13 (first current value acquisition step).

Next, in step S202, the discharge determination unit 332 determines whether or not the lead-acid battery B is in the discharge state based on the current value of the lead-acid battery B acquired in step S201 (discharge determination step). Specifically, in a case where the current value of the lead-acid battery B acquired in step S201 is smaller than the first threshold, it is determined that the lead-acid battery B is in the discharge (n-th discharge Dn) state, and in a case where the current value is equal to or larger than the first threshold, it is determined that the lead-acid battery B is in a stop state or a charge (n-th charge Cn) state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state.

In a case where it is determined in step S202 that the lead-acid battery B is in the stop state or the charge (n-th charge Cn) state, the processing returns to step S201, and in a case where it is determined in step S202 that the lead-acid battery B is in the discharge (n-th discharge Dn) state, the processing proceeds to step S203.

In step S203, the discharge current value integration unit 233 integrates the discharge current values from the start of the discharge of the lead-acid battery B, and calculates the integrated discharge capacity value from the start of the discharge of the lead-acid battery B (integrated discharge capacity value calculation step).

Next, in step S204, the second current value acquisition unit 234 acquires, from the recording unit 12, information regarding the current value of the lead-acid battery B input to the recording unit 12 via the measurement unit 11 from the start to the end of the processing in the state determination unit 13 (second current value acquisition step).

Next, in step S205, the charge/discharge determination unit 335 determines whether the lead-acid battery B is in the discharge state, the stop state, or the charge state based on the current value of the lead-acid battery B acquired in step S204 (charge/discharge determination step).

Here, in a case where the current value of the lead-acid battery B acquired in step S204 is smaller than the first threshold (the current value < the first threshold), the charge/discharge determination unit 335 determines that the lead-acid battery B is in the discharge (n-th discharge Dn) state,

in a case where the first threshold $\leq$ the current value $\leq$ the second threshold, the charge/discharge determination unit 335 determines that the lead-acid battery B is in the stop state, and
in a case where the current value > the second threshold, the charge/discharge determination unit 335 determines that the lead-acid battery B is in the charge (n+1-th charge Cn+1) state.

The first threshold is the same value as the above-described first threshold, and the second threshold is a positive current value near 0 amperes.

In a case where it is determined in step S205 that the lead-acid battery B is in the stop state, the low SOC dwell time calculation unit 336 sets the current value to 0 in step S206, and calculates the low SOC dwell time $t_{LSOC}$ in step S207 (low SOC dwell time calculation step). In step S207, the low SOC dwell time calculation unit 336 determines whether or not an SOC at a corresponding time point at which the determination result in step S205 indicates the stop state is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 136 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above.

Then, after step S207, the processing returns to step S203.

In a case where the determination result in step S205 indicates the discharge (n-th discharge Dn) state, the processing returns to step S203.

In a case where the determination result in step S205 indicates the charge (n+1-th charge Cn+1) state, in step S208, the capacity turnover value calculation unit 337 calculates the capacity turnover value during operation (hereinafter, referred to as the CT value during operation) (capacity turnover value calculation step).

A detailed flow of processing in the capacity turnover value calculation unit 337 in step S208 will be described with reference to FIG. 18.

First, in step S2081, the previous capacity turnover value acquisition unit 337a acquires, from the recording unit 12, a capacity turnover value before the start of the processing in the state determination unit 13 (before the time point a1 in FIG. 3) (hereinafter, referred to as a previous CT value) (previous CT value acquisition step). The previous CT value is a CT value during operation calculated in step S208 at the time of the previous processing in the state determination unit 13, and already input from the capacity turnover value calculation unit 337 to the recording unit 12.

Next, in step S2082, the integrated discharge capacity acquisition unit 337b acquires information regarding the integrated discharge capacity value from the start of the discharge of the lead-acid battery B calculated in step S203 (integrated discharge capacity value acquisition step).

Next, in step S2083, the rated capacity acquisition unit 338c acquires information regarding the rated capacity (Ah) of the lead-acid battery B from the recording unit 12 (rated capacity acquisition step).

Next, in step S2084, the low SOC dwell time acquisition unit 337d acquires information regarding the low SOC dwell time $t_{LSOC}$ calculated in step S207 (low SOC dwell time acquisition step).

Next, in step S2085, the low-SOC-dwell-time-based correction coefficient calculation unit 337e calculates the low-SOC-dwell-time-based correction coefficient $K_{t\_LSOC}$ by using the low SOC dwell time $t_{LSOC}$ acquired in step S2084 (low-SOC-dwell-time-based correction coefficient calculation step). As described above, the low-SOC-dwell-time-based correction coefficient $K_{t\_LSOC}$ is calculated with reference to the graph illustrating the relationship between the low SOC dwell time $t_{LSOC}$ and the low-SOC-dwell-time-based correction coefficient $K_{t\_LSOC}$ illustrated in FIG. 10.

Then, in step S2086, the capacity turnover value computation unit 337f calculates the CT value during operation by Formula (5) using the previous CT value acquired in step S2081, the integrated discharge capacity from the start of the lead-acid battery B acquired in step S2082, the rated capacity (Ah) of the lead-acid battery B acquired in step S2083, and the low-SOC-dwell-time-based correction coefficient $K_{t\_LSOC}$ calculated in step S2085 (capacity turnover value computation step).

As a result, the processing in the capacity turnover value calculation unit 337 in step S208 ends.

In step S209, the life estimation unit 338 of the state determination unit 13 estimates the remaining life of the lead-acid battery B by comparing the CT value from the beginning to the end of life acquired from the recording unit 12 with the CT value during operation calculated in step S208. That is, the life estimation unit 338 estimates the remaining life of the lead-acid battery B from a CT value obtained by subtracting the CT value during operation from the CT value from the beginning to the end of life.

Then, the life estimation unit 338 records an estimation result of the life estimation unit 338 including the CT value during operation in the recording unit 12. The life estimation unit 338 sets the low SOC dwell time $t_{LSOC}$ to 0 and records the low SOC dwell time $t_{LSOC}$ in the recording unit 12.

Accordingly, the processing in the state determination unit 13 ends.

As described above, in the lead-acid battery life estimation method according to the third embodiment, in the capacity turnover value calculation step (step S208), the capacity turnover value during operation is calculated using the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC. As a result, it is possible to calculate the capacity turnover value during operation in consideration of the low SOC dwell time, to consider the progress of deterioration due to softening or sulfation of the active material, and to provide the lead-acid battery life estimation method capable of accurately estimating the remaining life of the lead-acid battery.

In the lead-acid battery life estimation method according to the third embodiment, in a case where the lead-acid battery B is a bipolar lead-acid battery, it is possible to provide a lead-acid battery life estimation method capable of accurately estimating the remaining life of the bipolar lead-acid battery.

(Fourth Embodiment)

Next, the lead-acid battery system and the lead-acid battery life estimation method according to the fourth embodiment of the present invention will be described with reference to FIGS. 19 to 23.

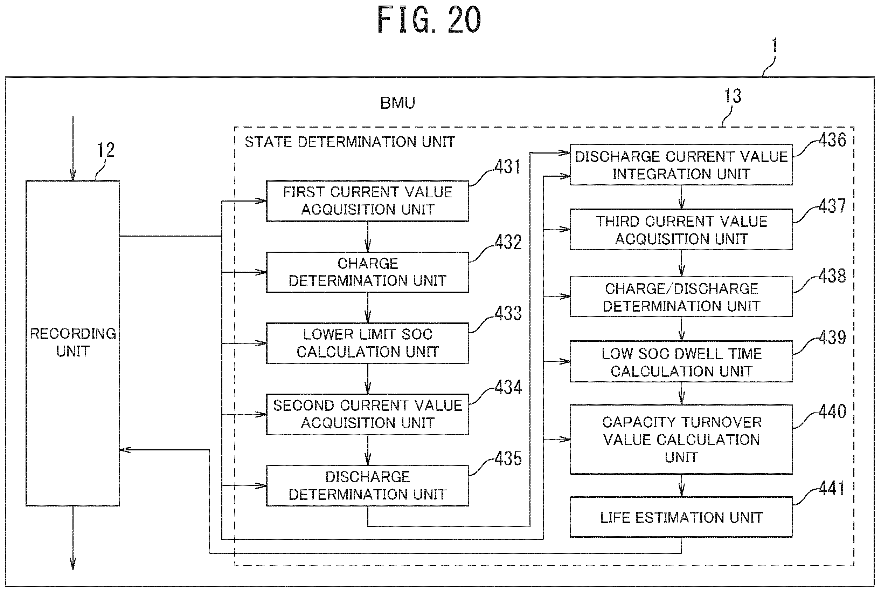

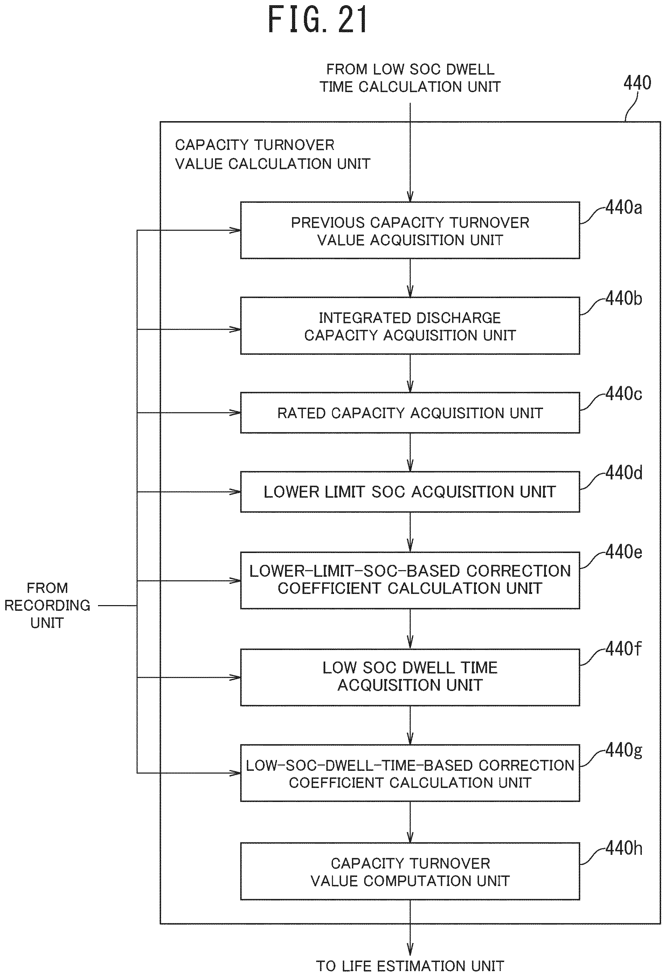

FIG. 19 is a diagram for describing start and end timings of processing in a state determination unit 13 and calculation of an SOC at the start of a charge immediately before a discharge to be subjected to calculation of the capacity turnover value during operation as a lower limit SOC in the lead-acid battery system according to the fourth embodiment of the present invention. FIG. 20 is a block diagram illustrating internal configurations of a recording unit and the state determination unit included in the BMU illustrated in FIG. 2 in the lead-acid battery system according to the fourth embodiment of the present invention. FIG. 21 is a block diagram illustrating an internal configuration of a capacity turnover value calculation unit included in the state determination unit illustrated in FIG. 20.

The lead-acid battery system S according to the fourth embodiment has the same basic configuration as the lead-acid battery system S according to the first embodiment, and is different from the lead-acid battery system S according to the first embodiment in a configuration of a state determination unit 13.

The state determination unit 13 of the fourth embodiment calculates the lower limit SOC, which is an SOC having the smallest value when a lead-acid battery B is charged and discharged once, respectively, similarly to the state determination unit 13 of the first embodiment. Then, the state determination unit 13 calculates the capacity turnover value during operation by using both a lower-limit-SOC-based correction coefficient $K_{LSOC}$ calculated based on the calculated lower limit SOC and a low-SOC-dwell-time-based correction coefficient $K_{t\_LSOC}$ calculated based on a low SOC dwell time $t_{LSOC}$ which is an elapsed time until the next discharge or charge starts when a discharge ends below a reference SOC.

However, unlike the state determination unit 13 of the first embodiment, as illustrated in FIG. 19, the state determination unit 13 of the fourth embodiment calculates $SOC_{end(n-1)}$ at the start of a charge (n-th charge Cn) immediately before a discharge (n-th discharge Dn) of the lead-acid battery B to be subjected to calculation of the capacity turnover value during operation as the lower limit SOC.

As illustrated in FIG. 19, processing in the state determination unit 13 in the lead-acid battery system S according to the fourth embodiment is executed from a time point a2 at the time of the n-1-th discharge Dn-1 before the n-th charge Cn of the lead-acid battery B to a time point b2 after the end of the n-th discharge Dn, and the processing is repeated at the time of charging and discharging.

Therefore, as illustrated in FIG. 20, the state determination unit 13 includes a first current value acquisition unit 431, a charge determination unit 432, a lower limit SOC calculation unit 433, a second current value acquisition unit 434, a discharge determination unit 435, a discharge current value integration unit 436, a third current value acquisition unit 437, a charge/discharge determination unit 438, a low SOC dwell time calculation unit 439, a capacity turnover value calculation unit 440, and a life estimation unit 441 in order to estimate the remaining life of the lead-acid battery B.

The first current value acquisition unit 431 acquires, from a recording unit 12, information regarding a current value of the lead-acid battery B input to the recording unit 12 via a measurement unit 11 from the start to the end of the processing in the state determination unit 13.

In addition, the charge determination unit 432 determines whether or not the lead-acid battery B is in a charge state based on the current value of the lead-acid battery B acquired by the first current value acquisition unit 431. Specifically, in a case where the current value of the lead-acid battery B acquired by the first current value acquisition unit 431 is larger than a second threshold, it is determined that the lead-acid battery B is in the charge state, and in a case where the current value is equal to or smaller than the second threshold, it is determined that the lead-acid battery B is not in the charge state. The second threshold is a current value similar to the above-described second threshold, and is a positive current value near 0 amperes. The second threshold is set in a setting unit 14 and recorded in the recording unit 12, and the charge determination unit 432 acquires information regarding the second threshold from the recording unit 12.

In addition, the lower limit SOC calculation unit 433 calculates the lower limit SOC which is the SOC having the smallest value when the lead-acid battery B is charged and discharged once, respectively. Specifically, in a case where the determination result of the charge determination unit 432 indicates the charge (n-th charge Cn) state, the lower limit SOC calculation unit 433 calculates $SOC_{end(n-1)}$ (see FIG. 19) at the start of the charge (n-th charge Cn) immediately before the discharge (n-th discharge Dn) of the lead-acid battery B to be subjected to calculation of the capacity turnover value during operation as the lower limit SOC. Here, the lower limit SOC calculation unit 433 acquires, from the recording unit 12, a rated capacity of the lead-acid battery B, the total charge amount of the lead-acid battery B from completion of an equalization

EP 4 474 842 A1

charge to a start time point of the n-th charge Cn recorded in the recording unit 12 at the start of the n-th charge Cn, and the total discharge amount (negative value) of the lead-acid battery B from the completion of the equalization charge to the start time point of the n-th charge Cn recorded in the recording unit 12 at the start of the n-th charge Cn. Then, the lower limit SOC calculation unit 433 calculates $SOC_{end(n-1)}$ by the following Formula (6) similar to the Formula (1) described above.

[Mathematical Formula 6]

$$SOC_{end(n-1)} = \frac{(\text{Rated capacity} + \text{Total charge amount} + \text{Total discharge amount})}{\text{Rated capacity}} \times 100 \quad \cdots (6)$$

The second current value acquisition unit 434 acquires, from the recording unit 12, information regarding the current value of the lead-acid battery B input to the recording unit 12 via the measurement unit 11 from the start to the end of the processing in the state determination unit 13.

In addition, the discharge determination unit 435 determines whether or not the lead-acid battery B is in a discharge state based on the current value of the lead-acid battery B acquired by the second current value acquisition unit 434. Specifically, in a case where the current value of the lead-acid battery B acquired by the second current value acquisition unit 434 is smaller than a first threshold, it is determined that the lead-acid battery B is in the discharge state, and in a case where the current value is equal to or larger than the first threshold, it is determined that the lead-acid battery B is not in the discharge state. The first threshold is a current value similar to the first threshold described above, and is a negative current value near 0 amperes. The first threshold is set in the setting unit 14 and recorded in the recording unit 12, and the discharge determination unit 435 acquires information regarding the first threshold from the recording unit 12.

In addition, the discharge current value integration unit 436 integrates discharge current values after the start of the discharge of the lead-acid battery B, and calculates an integrated discharge capacity value after the start of the discharge of the lead-acid battery B.

The third current value acquisition unit 437 acquires, from the recording unit 12, information regarding the current value of the lead-acid battery B input to the recording unit 12 via the measurement unit 11 from the start to the end of the processing in the state determination unit 13.

In addition, the charge/discharge determination unit 438 determines whether the lead-acid battery B is in a discharge state, the stop state, or the charge state based on the current value of the lead-acid battery B acquired by the third current value acquisition unit 437.

Here, in a case where the current value of the lead-acid battery B acquired by the third current value acquisition unit 437 is smaller than the first threshold (the current value < the first threshold), the charge/discharge determination unit 438 determines that the lead-acid battery B is in the discharge state,

in a case where the first threshold $\leq$ the current value $\leq$ the second threshold, the charge/discharge determination unit 438 determines that the lead-acid battery B is in the stop state, and
in a case where the current value > the second threshold, the charge/discharge determination unit 438 determines that the lead-acid battery B is in the charge state.

The first threshold is the same value as the above-described first threshold, and the second threshold is also the same value as the above-described second threshold.

The low SOC dwell time calculation unit 439 determines whether or not an SOC at the corresponding time point is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 439 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above.

Next, in a case where the determination result of the charge/discharge determination unit 438 indicates that the lead-acid battery B is in the charge state, the capacity turnover value calculation unit 440 calculates the capacity turnover value during operation (hereinafter, referred to as the CT value during operation).

An internal configuration of the capacity turnover value calculation unit 440 will be described in more detail with reference to FIG. 21.

The capacity turnover value calculation unit 440 includes a previous capacity turnover value acquisition unit 440a, an integrated discharge capacity acquisition unit 440b, a rated capacity acquisition unit 440c, a lower limit SOC acquisition unit 440d, a lower-limit-SOC-based correction coefficient calculation unit 440e, a low SOC dwell time acquisition unit 440f, a low-SOC-dwell-time-based correction coefficient calculation unit 440g, and a capacity turnover value computation unit 440h.

In a case where the charge/discharge determination unit 438 determines that the lead-acid battery B is in the charge state, the previous capacity turnover value acquisition unit 440a acquires a capacity turnover value before the start of the processing in the state determination unit 13 (before the time point a2 in FIG. 19) (hereinafter, referred to as a previous CT value) from the recording unit 12. The previous CT value is a CT value during operation calculated by the capacity turnover value calculation unit 440 at the time of the previous processing in the state determination unit 13, and already input from the capacity turnover value calculation unit 440 to the recording unit 12.

In addition, the integrated discharge capacity acquisition unit 440b acquires information regarding the integrated discharge capacity value from the start of the discharge of the lead-acid battery B calculated by the discharge current value integration unit 436.

Further, the rated capacity acquisition unit 440c acquires information regarding the rated capacity (Ah) of the lead-acid battery B from the recording unit 12.

The lower limit SOC acquisition unit 440d acquires information regarding the lower limit SOC calculated by the lower limit SOC calculation unit 433.

The lower-limit-SOC-based correction coefficient calculation unit 440e calculates the lower-limit-SOC-based correction coefficient $K_{LSOC}$ by using the lower limit SOC acquired by the lower limit SOC acquisition unit 440d. The lower-limit-SOC-based correction coefficient $K_{LSOC}$ is calculated with reference to a graph illustrating a relationship between the lower limit SOC and the lower-limit-SOC-based correction coefficient $K_{LSOC}$ illustrated in FIG. 9. Here, in FIG. 9, the lower-limit-SOC-based coefficient between the respective numerical values is calculated by creating an approximation curve from values of two adjacent points.

The low SOC dwell time acquisition unit 440f acquires information regarding the low SOC dwell time $t_{LSOC}$ calculated by the low SOC dwell time calculation unit 439.

The low-SOC-dwell-time-based correction coefficient calculation unit 440g calculates the low-SOC-dwell-time-based correction coefficient $K_{t\_LSOC}$ by using the low SOC dwell time $t_{LSOC}$ acquired by the low SOC dwell time acquisition unit 440f. The low-SOC-dwell-time-based correction coefficient $K_{t\_LSOC}$ is calculated with reference to a graph illustrating a relationship between the low SOC dwell time $t_{LSOC}$ and the low-SOC-dwell-time-based correction coefficient $K_{t\_LSOC}$ illustrated in FIG. 10. In the Ostwald ripening in which the SOC is predicted to be in the low SOC region (a region below the reference SOC (for example, 30% in the present embodiment)), a crystal volume increases in proportion to time, and the low-SOC-dwell-time-based correction coefficient $K_{t\_LSOC}$ increases in proportion to the low SOC dwell time $t_{LSOC}$.

Further, the capacity turnover value computation unit 440h calculates the CT value during operation by Formula (3) described above using the previous CT value acquired by the previous capacity turnover value acquisition unit 440a, the integrated discharge capacity from the start of the discharge of the lead-acid battery B acquired by the integrated discharge capacity acquisition unit 440b, the rated capacity (Ah) of the lead-acid battery B acquired by the rated capacity acquisition unit 440cc, the lower-limit-SOC-based correction coefficient $K_{LSOC}$ calculated by the lower-limit-SOC-based correction coefficient calculation unit 440e, and the low-SOC-dwell-time-based correction coefficient $K_{t\_LSOC}$ calculated by the low-SOC-dwell-time-based correction coefficient calculation unit 440g.

Then, the life estimation unit 441 of the state determination unit 13 estimates the remaining life of the lead-acid battery B by comparing the CT value from the beginning to the end of life acquired from the recording unit 12 with the CT value during operation calculated by the capacity turnover value calculation unit 440. That is, the life estimation unit 441 estimates the remaining life of the lead-acid battery B from a CT value obtained by subtracting the CT value during operation from the CT value from the beginning to the end of life.

Then, the life estimation unit 441 records an estimation result of the life estimation unit 441 including the CT value during operation in the recording unit 12. The life estimation unit 441 sets the low SOC dwell time $t_{LSOC}$ to 0 and records the low SOC dwell time $t_{LSOC}$ in the recording unit 12.

As described above, in the lead-acid battery system S according to the fourth embodiment, the capacity turnover value calculation unit 138 calculates the CT value during operation by using both the lower-limit-SOC-based correction coefficient $K_{LSOC}$ calculated based on the lower limit SOC calculated by the lower limit SOC calculation unit 433 that calculates the lower limit SOC which is the SOC having the smallest value when the lead-acid battery B is charged and discharged once, and the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC. As a result, it is possible to calculate the CT value during operation in consideration of both the lower limit SOC and the low SOC dwell time $t_{LSOC}$, to consider the progress of deterioration due to softening or sulfation of the active material, and to provide the lead-acid battery system S capable of accurately estimating the remaining life of the lead-acid battery B.

In the lead-acid battery system S according to the fourth embodiment, the lower limit SOC calculation unit 433 calculates $SOC_{end(n-1)}$ at the start of the charge (n-th charge Cn) immediately before the discharge (n-th discharge Dn) of the lead-acid battery B to be subjected to calculation of the capacity turnover value during operation as the lower limit SOC, and the capacity turnover value calculation unit 440 calculates the lower-limit-SOC-based correction coefficient $K_{LSOC}$ based on the lower limit SOC calculated by the lower limit SOC calculation unit 433. As a result, the lower limit SOC can be determined and calculated at the start of the charge (n-th charge Cn) immediately before the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery system S according to the fourth embodiment, in a case where the lead-acid battery B is a bipolar lead-acid battery, it is possible to provide the lead-acid battery system S capable of accurately estimating the remaining life of the bipolar lead-acid battery.

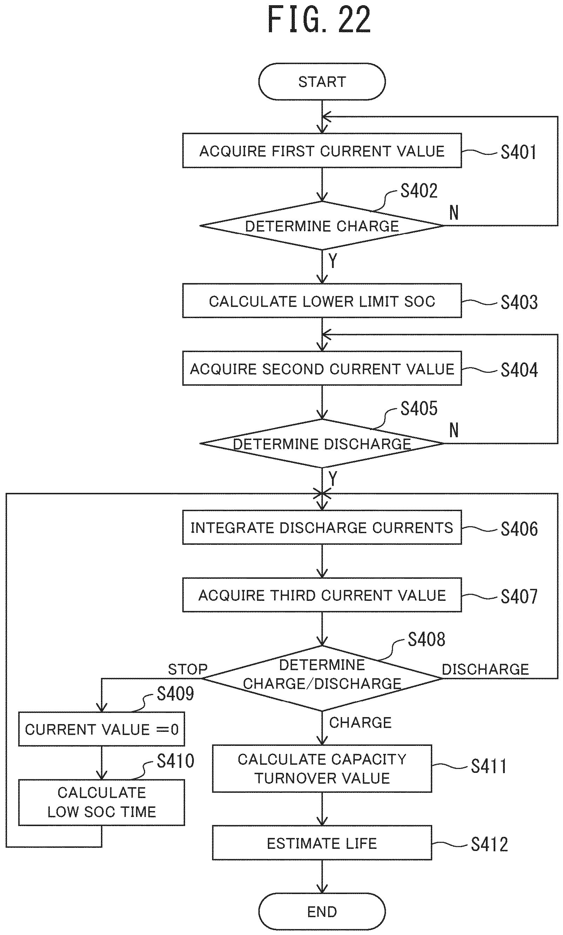

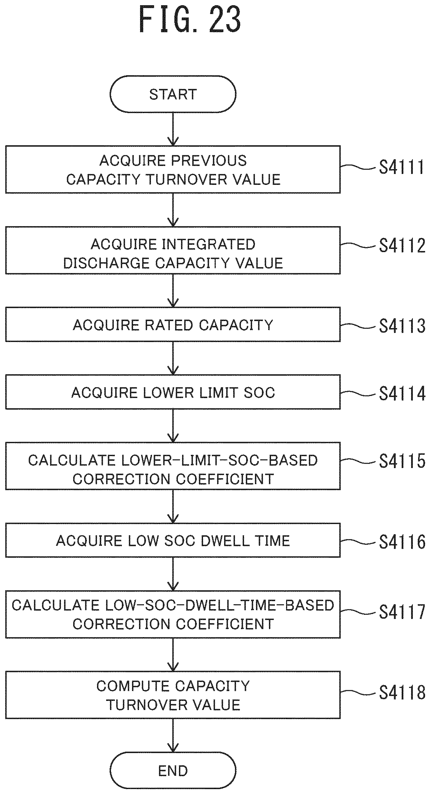

Next, the lead-acid battery life estimation method according to the fourth embodiment will be described with reference to a flowchart illustrating a flow of the processing in the state determination unit illustrated in FIG. 22 and a flowchart illustrating a flow of processing of step S411 (capacity turnover value calculation step) in the flowchart of FIG. 22 illustrated in FIG. 23.

The state determination unit 13 starts the processing from the time point a2 in FIG. 19. First, as illustrated in FIG. 22, in step S401, the first current value acquisition unit 431 of the state determination unit 13 acquires, from the recording unit 12, information regarding the current value of the lead-acid battery B input to the recording unit 12 via the measurement unit 11 from the start to the end (the time point b2 in FIG. 19) of the processing in the state determination unit 13 (first current value acquisition step).

Next, in step S402, the charge determination unit 432 determines whether or not the lead-acid battery B is in the charge state based on the current value of the lead-acid battery B acquired in step S401 (charge determination step). Specifically, in a case where the current value of the lead-acid battery B acquired in step S401 is larger than a second threshold, it is determined that the lead-acid battery B is in the charge state, and in a case where the current value is equal to or smaller than the second threshold, it is determined that the lead-acid battery B is not in the charge state. The second threshold is a current value similar to the above-described second threshold, and is a positive current value near 0 amperes. The second threshold is set in a setting unit 14 and recorded in the recording unit 12, and the charge determination unit 432 acquires information regarding the second threshold from the recording unit 12.

Then, in a case where the determination result in step S401 indicates the charge (n-th charge Cn) state, the processing proceeds to step S403, and in a case where the determination result does not indicate the charge state, the processing returns to step S401.

In step S403, the lower limit SOC calculation unit 433 calculates the lower limit SOC which is the SOC having the smallest value when the lead-acid battery B is charged and discharged once, respectively. Specifically, in a case where the determination result in step 402 indicates the charge (n-th charge Cn) state, the lower limit SOC calculation unit 433 calculates $SOC_{end(n-1)}$ (see FIG. 19) at the start of the charge (n-th charge Cn) immediately before the discharge (n-th discharge Dn) of the lead-acid battery B to be subjected to calculation of the capacity turnover value during operation as the lower limit SOC. Here, the lower limit SOC calculation unit 433 acquires, from the recording unit 12, a rated capacity of the lead-acid battery B, the total charge amount of the lead-acid battery B from completion of an equalization charge to a start time point of the n-th charge Cn recorded in the recording unit 12 at the start of the n-th charge Cn, and the total discharge amount (negative value) of the lead-acid battery B from the completion of the equalization charge to the start time point of the n-th charge Cn recorded in the recording unit 12 at the start of the n-th charge Cn. Then, the lower limit SOC calculation unit 433 calculates $SOC_{end(n)}$ by Formula (6) described above.

Next, in step S404, the second current value acquisition unit 434 acquires, from the recording unit 12, information regarding the current value of the lead-acid battery B input to the recording unit 12 via the measurement unit 11 from the start to the end of the processing in the state determination unit 13 (second current value acquisition step).

Next, in step S405, the discharge determination unit 435 determines whether or not the lead-acid battery B is in the discharge state based on the current value of the lead-acid battery B acquired in step S404 (discharge determination step). Specifically, in a case where the current value of the lead-acid battery B acquired in step S404 is smaller than a first threshold, it is determined that the lead-acid battery B is in the discharge state, and in a case where the current value is equal to or larger than the first threshold, it is determined that the lead-acid battery B is not in the discharge state. The first threshold is specifically a negative current value near 0 amperes, and in a case where the current value is smaller than the first threshold, it is determined that the lead-acid battery B is in the discharge state, and in a case where the current value is equal to or larger than the first threshold, it is determined that the lead-acid battery B is in the stop state or the charge state. The first threshold for the discharge determination is set by a setting unit 14 and recorded in the recording unit 12, and the discharge determination unit 435 acquires information regarding the first threshold from the recording unit 12.

In a case where the determination result in step S405 indicates the discharge (n-th discharge Dn) state, the processing proceeds to step S406, and in a case where the determination result does not indicate the discharge state, the processing returns to step S404.

In step S406, the discharge current value integration unit 436 integrates the discharge current values from the start of the discharge of the lead-acid battery B, and calculates the integrated discharge capacity value from the start of the discharge of the lead-acid battery B (integrated discharge capacity value calculation step).

Next, in step S407, the third current value acquisition unit 437 acquires, from the recording unit 12, information regarding the current value of the lead-acid battery B input to the recording unit 12 via the measurement unit 11 from the start to the end of the processing in the state determination unit 13 (third current value acquisition step).

Next, in step S408, the charge/discharge determination unit 438 determines whether the lead-acid battery B is in the discharge state, the stop state, or the charge state based on the current value of the lead-acid battery B acquired in step S407 (charge/discharge determination step).

Here, in a case where the current value of the lead-acid battery B acquired in step S407 is smaller than the first threshold (the current value < a first threshold), the charge/discharge determination unit 438 determines that the lead-acid battery B is in the discharge state,

in a case where the first threshold ≤ the current value ≤ a second threshold, the charge/discharge determination unit 438 determines that the lead-acid battery B is in the stop state, and

in a case where the current value > the second threshold, the charge/discharge determination unit 438 determines that the lead-acid battery B is in the charge state.

The first threshold is the same value as the above-described first threshold, and the second threshold is also a value similar to the above-described second threshold.

In a case where the determination result in step S408 indicates the stop state, the processing proceeds to step S409. In a case where it is determined that the determination result indicates the charge (n+1-th charge Cn+1) state, the processing proceeds to step S411. In a case where it is determined that the determination result indicates the discharge (n-th discharge Dn) state, the processing returns to step S406.

In step S409, the low SOC dwell time calculation unit 439 sets the current value to 0, and in step S410, calculates the low SOC dwell time $t_{LSOC}$ (low SOC dwell time calculation step). As described above, the low SOC dwell time calculation unit 439 determines whether or not an SOC at the corresponding time point is below the reference SOC (for example, 30% in the present embodiment), and calculates the low SOC dwell time $t_{LSOC}$ by integrating a time for which the SOC is below the reference SOC when it is determined that the SOC is below the reference SOC. As illustrated in FIG. 5, the low SOC dwell time $t_{LSOC}$ is an elapsed time until the next discharge or charge starts when a discharge ends below the reference SOC (for example, 30% in the present embodiment). In a case where there are a plurality of elapsed times, the low SOC dwell time calculation unit 136 calculates the low SOC dwell time $t_{LSOC}$ by integrating the plurality of elapsed times. In a case where it is determined that the SOC at the corresponding time point is equal to or higher than the reference SOC, the low SOC dwell time $t_{LSOC}$ is not counted. In addition, the low SOC dwell time calculation unit 439 acquires, from the recording unit 12, the rated capacity of the lead-acid battery B, the total charge amount of the lead-acid battery B from completion of an equalization charge to a corresponding time point, and the total discharge amount (negative value) of the lead-acid battery B from the completion of the equalization charge to the corresponding time point, and calculates the SOC at the corresponding time point by Formula (1) described above. Then, after step S410, the processing returns to step S406.

In step S411, the capacity turnover value calculation unit 440 calculates the capacity turnover value during operation (hereinafter, referred to as the CT value during operation) (capacity turnover value calculation step).

A detailed flow of processing in the capacity turnover value calculation unit 440 in step S411 will be described with reference to FIG. 23.

First, in step S4111, the previous capacity turnover value acquisition unit 440a acquires, from the recording unit 12, a capacity turnover value before the start of the processing in the state determination unit 13 (before the time point a2 in FIG. 19) (hereinafter, referred to as a previous CT value) (previous CT value acquisition step). The previous CT value is a CT value during operation calculated in step S411 at the time of the previous processing in the state determination unit 13, and already input from the capacity turnover value calculation unit 440 to the recording unit 12.

Next, in step S4112, the integrated discharge capacity acquisition unit 440b acquires information regarding the integrated discharge capacity value from the start of the discharge of the lead-acid battery B calculated in step S406 (integrated discharge capacity value acquisition step).

Next, in step S4113, the rated capacity acquisition unit 440c acquires information regarding the rated capacity (Ah) of the lead-acid battery B from the recording unit 12 (rated capacity acquisition step).

Next, in step S4114, the lower limit SOC acquisition unit 138d acquires information regarding the lower limit SOC calculated in step S8 (lower limit SOC acquisition step).

Next, in step S4115, the lower-limit-SOC-based correction coefficient calculation unit 440e calculates the lower-limit-SOC-based correction coefficient $K_{LSOC}$ by using the lower limit SOC acquired in step S4114 (lower-limit-SOC-based correction coefficient calculation step). As described above, the lower-limit-SOC-based correction coefficient $K_{LSOC}$ is calculated with reference to the graph illustrating the relationship between the lower limit SOC and the lower-limit-SOC-based correction coefficient $K_{LSOC}$ illustrated in FIG. 9.

Next, in step S4116, the low SOC dwell time acquisition unit 440f acquires information regarding the low SOC dwell time $t_{LSOC}$ calculated in step S410 (low SOC dwell time acquisition step).

Next, in step S4117, the low-SOC-dwell-time-based correction coefficient calculation unit 440g calculates the low-SOC-dwell-time-based correction coefficient $K_{t\_LSOC}$ by using the low SOC dwell time $t_{LSOC}$ acquired in step S4116 (low-SOC-dwell-time-based correction coefficient calculation step). As described above, the low-SOC-dwell-time-based correction coefficient $K_{t\_LSOC}$ is calculated with reference to the graph illustrating the relationship between the low SOC dwell time $t_{LSOC}$ and the low-SOC-dwell-time-based correction coefficient $K_{t\_LSOC}$ illustrated in FIG. 10.

Then, in step S4118, the capacity turnover value computation unit 440h calculates the CT value during operation by Formula (3) described above using the previous CT value acquired in step S4111, the integrated discharge capacity from the start of the discharge of the lead-acid battery B acquired in step S4112, the rated capacity (Ah) of the lead-acid battery B acquired in step S4113, the lower-limit-SOC-based correction coefficient $K_{LSOC}$ calculated in step S4115, and the low-SOC-dwell-time-based correction coefficient $K_{t\_LSOC}$ calculated in step S4117 (capacity turnover value computation step).

As a result, the processing in the capacity turnover value calculation unit 440 in step S411 ends.

In step S412, the life estimation unit 411 of the state determination unit 13 estimates the remaining life of the lead-acid battery B by comparing the CT value from the beginning to the end of life acquired from the recording unit 12 with the CT value during operation calculated in step S411. That is, the life estimation unit 411 estimates the remaining life of the lead-acid battery B from a CT value obtained by subtracting the CT value during operation from the CT value from the beginning to the end of life.

Then, the life estimation unit 411 records an estimation result of the life estimation unit 411 including the CT value during operation in the recording unit 12. The life estimation unit 411 sets the low SOC dwell time $t_{LSOC}$ to 0 and records the low SOC dwell time $t_{LSOC}$ in the recording unit 12.

Accordingly, the processing in the state determination unit 13 ends.

As described above, in the lead-acid battery life estimation method according to the fourth embodiment, in the capacity turnover value calculation step (step S411), the CT value during operation is calculated using both the lower-limit-SOC-based correction coefficient $K_{LSOC}$ calculated based on the lower limit SOC calculated in the lower limit SOC calculation step (step S403) of calculating the lower limit SOC which is the SOC having the smallest value when the lead-acid battery B is charged and discharged once, respectively, and the low-SOC-dwell-time-based correction coefficient $K_{t\_LSOC}$ calculated based on the low SOC dwell time $t_{LSOC}$ which is the elapsed time until the next discharge or charge starts when a discharge ends below the reference SOC. As a result, it is possible to calculate the CT value during operation in consideration of both the lower limit SOC and the low SOC dwell time $t_{LSOC}$, to consider the progress of deterioration due to softening or sulfation of the active material, and to provide the lead-acid battery life estimation method capable of accurately estimating the remaining life of the lead-acid battery B.

In the lead-acid battery life estimation method according to the fourth embodiment, in the lower limit SOC calculation step (step S403), $SOC_{end(n-1)}$ at the start of the charge (n-th charge Cn) immediately before the discharge (n-th discharge Dn) of the lead-acid battery B to be subjected to calculation of the capacity turnover value during operation is calculated as the lower limit SOC, and in the capacity turnover value calculation step (step S411), the lower-limit-SOC-based correction coefficient $K_{LSOC}$ is calculated based on the lower limit SOC calculated in the lower limit SOC calculation step (step S403). As a result, the lower limit SOC can be determined and calculated at the start of the charge (n-th charge Cn) immediately before the discharge (n-th discharge Dn) to be subjected to calculation of the capacity turnover value during operation, and the lower-limit-SOC-based correction coefficient $K_{LSOC}$ can be appropriately calculated based on the calculated lower limit SOC.

In the lead-acid battery life estimation method according to the fourth embodiment, in a case where the lead-acid battery B is a bipolar lead-acid battery, it is possible to provide a lead-acid battery system S capable of accurately estimating the remaining life of the bipolar lead-acid battery.

Although the embodiments of the present invention have been described above, the present invention is not limited thereto, and various modifications and improvements can be made therein.

For example, in the lead-acid battery system S and the lead-acid battery life estimation method according to the first and second embodiments, the lower limit SOC calculation units 137 and 236 calculate $SOC_{end(n)}$ after the end of the discharge (n-th discharge Dn) of the lead-acid battery B to be subjected to calculation of the capacity turnover value during operation as the lower limit SOC.

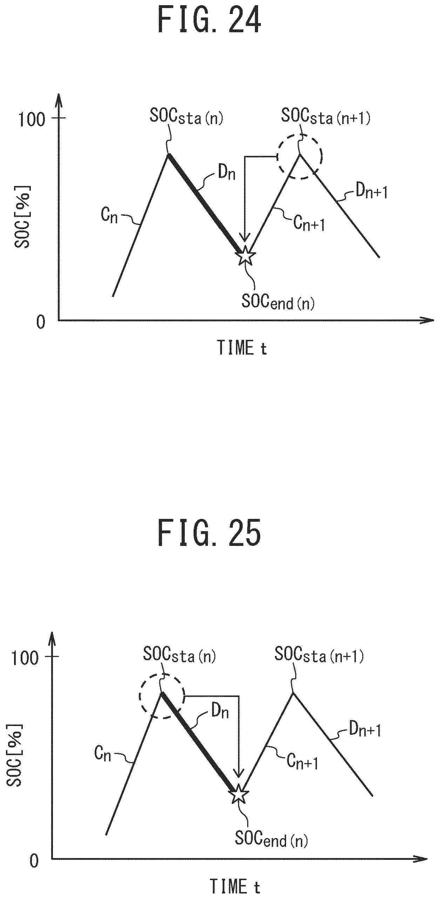

In this case, as illustrated in FIG. 24, $SOC_{sta(n+1)}$ after the end of the charge (n+1-th charge Cn+1) after the discharge (n-th discharge Dn) of the lead-acid battery B to be subjected to calculation of the CT value during operation is calculated in advance, and the charge amount at the time of the charge (n+1-th charge Cn+1) may be subtracted to calculate $SOC_{sta(n+1)}$ after the end of the discharge (n-th discharge Dn) as the lower limit SOC.

That is, the lower limit SOC calculation units 137 and 236 acquire, from the recording units 12, the rated capacity, the total charge amount of the lead-acid battery B from completion of an equalization charge to an end time point of the (n+1)-th charge Cn+1 recorded in the recording unit 12 at the end of the (n+1)-th charge Cn+1, and the total discharge amount (negative value) of the lead-acid battery B from the completion of the equalization charge to the end time point of the (n+1)-th charge Cn+1 recorded in the recording unit 12 at the end of the (n+1)-th charge Cn+1. Then, the lower limit SOC calculation units 137 and 236 calculate $SOC_{sta(n+1)}$ by the following Formula (7) .
[Mathematical Formula 7]

$$SOC_{sta(n+1)} = \frac{(\text{Rated capacity} + \text{Total charge amount} + \text{Total discharge amount})}{\text{Rated capacity}} \times 100 \qquad \cdots (7)$$

Next, the charge amount at the time of the charge (n+1-th charge Cn+1) is acquired from the recording unit 12, and the charge amount is subtracted from the total charge amount of Formula (7) to calculate $SOC_{end(n)}$ after the end of the discharge (n-th discharge Dn) by the following Formula (8) as the lower limit SOC.
[Mathematical Formula 8]

$$SOC_{end(n)} = \frac{(\text{Rated capacity} + \text{Total charge amount} - \text{Charge amount} + \text{Total discharge amount})}{\text{Rated capacity}} \times 100 \qquad \cdots (8)$$

In the lead-acid battery system S and the lead-acid battery life estimation method according to the first and second embodiments, when $SOC_{end(n)}$ after the end of the discharge (n-th discharge Dn) of the lead-acid battery B to be subjected to calculation of the capacity turnover value during operation is calculated as the lower limit SOC, as illustrated in FIG. 25, the lower limit SOC calculation units 137 and 236 may calculate $SOC_{sta(n)}$ after the end of the charge (n-th charge Cn) before the discharge (n-th discharge Dn) of the lead-acid battery B to be subjected to calculation of the CT value during operation, and add a discharge amount (negative value) at the time of the discharge (n-th discharge Dn) to calculate $SOC_{end(n)}$ after the end of the discharge (n-th discharge Dn) as the lower limit SOC.
That is, the lower limit SOC calculation units 137 and 236 acquire, from the recording units 12, the rated capacity, the total charge amount of the lead-acid battery B from completion of an equalization charge to an end time point of the n-th charge Cn recorded in the recording unit 12 at the end of the n-th charge Cn, and the total discharge amount (negative value) of the lead-acid battery B from the completion of the equalization charge to the end time point of the n-th charge Cn recorded in the recording unit 12 at the end of the n-th charge Cn. Then, the lower limit SOC calculation units 137 and 236 calculate $SOC_{sta(n)}$ by the following Formula (9) .
[Mathematical Formula 9]

$$SOC_{sta(n)} = \frac{(\text{Rated capacity} + \text{Total charge amount} + \text{Total discharge amount})}{\text{Rated capacity}} \times 100 \qquad \cdots (9)$$

Next, the discharge amount (negative value) at the time of the discharge (n-th discharge Dn) is acquired from the recording unit 12, and the discharge amount is added to the total discharge amount of Formula (9) to calculate $SOC_{sta(n)}$ at the start of the discharge (n-th discharge Dn) as the lower limit SOC by the following Formula (10).
[Mathematical Formula 10]

$$SOC_{end(n)} = \frac{(\text{Rated capacity} + \text{Total charge amount} + \text{Total discharge amount} + \text{Discharge amount})}{\text{Rated capacity}} \times 100 \qquad \cdots (10)$$

In the lead-acid battery system S and the lead-acid battery life estimation method according to the fourth embodiment, the CT value during operation is calculated using both the lower-limit-SOC-based correction coefficient $K_{LSOC}$ and the low-SOC-dwell-time-based correction coefficient $K_{t\_LSOC}$, but the present invention is not limited thereto, and the capacity turnover value during operation may be calculated using at least one of the lower-limit-SOC-based correction coefficient $K_{LSOC}$ or the low-SOC-dwell-time-based correction coefficient $K_{t\_LSOC}$.

In the lead-acid battery system S and the lead-acid battery life estimation method according to the fourth embodiment, the lower limit SOC calculation unit 433 calculates $SOC_{end(n-1)}$ (see FIG. 19) at the start of the charge (n-th charge Cn) immediately before the discharge (n-th discharge Dn) of the lead-acid battery B to be subjected to calculation of the capacity turnover value during operation as the lower limit SOC.

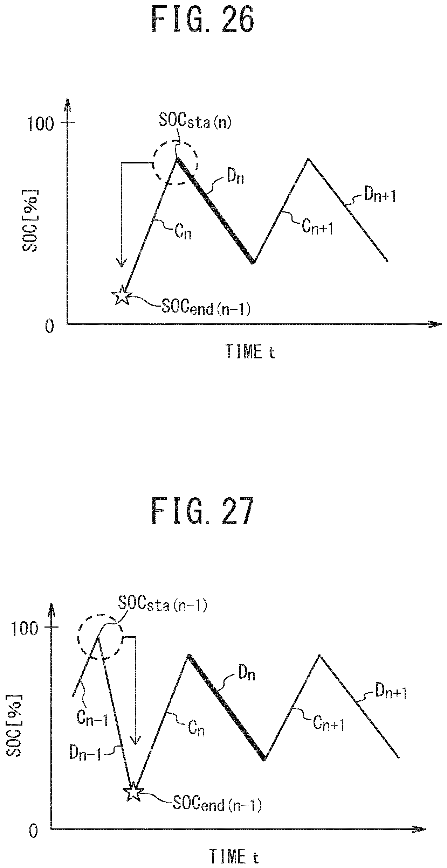

In this case, as illustrated in FIG. 26, $SOC_{sta(n)}$ after the end of the charge (n-th charge Cn+1) immediately before the discharge (n-th discharge Dn) of the lead-acid battery B to be subjected to calculation of the capacity turnover value during operation is calculated, and the charge amount at the time of the charge (n-th charge Cn) may be subtracted to calculate $SOC_{end(n-1)}$ at the start of the charge (n-th charge Cn) as the lower limit SOC.

That is, the lower limit SOC calculation unit 433 acquires, from the recording unit 12, the rated capacity, the total charge amount of the lead-acid battery B from the completion of the equalization charge to the end time point of the n-th charge Cn recorded in the recording unit 12 at the end of the n-th charge Cn, and the total discharge amount (negative value) of the lead-acid battery B from the completion of the equalization charge to the end time point of the n-th charge Cn recorded in the recording unit 12 at the end of the n-th charge Cn, and calculates $SOC_{sta(n)}$ by the following Formula (11).

[Mathematical Formula 11]

$$SOC_{sta(n)} = \frac{(\text{Rated capacity} + \text{Total charge amount} + \text{Total discharge amount})}{\text{Rated capacity}} \times 100 \qquad \cdots (11)$$

Next, the charge amount at the time of the charge (n-th charge Cn) is acquired from the recording unit 12, and the charge amount is subtracted from the total charge amount of Formula (11) to calculate $SOC_{end(n-1)}$ at the start of the charge (n-th charge Cn) as the lower limit SOC by the following Formula (12).

[Mathematical Formula 12]

$$SOC_{end(n-1)} = \frac{(\text{Rated capacity} + \text{Total charge amount} - \text{Charge amount} + \text{Total discharge amount})}{\text{Rated capacity}} \times 100 \qquad \cdots (12)$$

In addition, $SOC_{end(n-1)}$ at the start of the charge (n-th charge Cn) immediately before the discharge (n-th discharge Dn) of the lead-acid battery B to be subjected to calculation of the capacity turnover value during operation is calculated as the lower limit SOC. At this time, as illustrated in FIG. 27, $SOC_{sta(n-1)}$ after the end of the charge (n-1-th charge Cn-1) before the discharge (n-th discharge Dn) of the lead-acid battery B to be subjected to calculation of the capacity turnover value during operation is calculated, and the discharge amount (negative value) at the time of the discharge (n-1-th discharge Dn-1) may be added to calculate $SOC_{end(n-1)}$ at the start of the charge (n-th charge Cn) as the lower limit SOC.

That is, the lower limit SOC calculation unit 433 acquires, from the recording unit 12, the rated capacity, the total charge amount of the lead-acid battery B from the completion of the equalization charge to the end time point of the n-1-th charge Cn-1 recorded in the recording unit 12 at the end of the n-1-th charge Cn-1, and the total discharge amount (negative value) of the lead-acid battery B from the completion of the equalization charge to the end time point of the n-1-th charge Cn-1 recorded in the recording unit 12 at the end of the n-1-th charge Cn-1. Then, the lower limit SOC calculation unit 433 calculates $SOC_{sta(n-1)}$ by the following Formula (13).

[Mathematical Formula 13]

$$SOC_{sta(n-1)} = \frac{(\text{Rated capacity} + \text{Total charge amount} + \text{Total discharge amount})}{\text{Rated capacity}} \times 100 \qquad \cdots (13)$$

Next, the discharge amount (negative value) at the time of the discharge (n-1-th discharge Dn-1) is acquired from the recording unit 12, and the discharge amount is added to the total discharge amount of Formula (13) to calculate $SOC_{end(n-1)}$ at the start of the charge (n-th charge Cn) as the lower limit SOC by the following Formula (14).

[Mathematical Formula 14]

$$SOC_{end(n-1)} = \frac{(\text{Rated capacity} + \text{Total charge amount} + \text{Total discharge amount} + \text{Discharge amount})}{\text{Rated capacity}} \times 100 \quad \cdots (14)$$

In the lead-acid battery system S and the lead-acid battery life estimation method according to the first, second, and fourth embodiments, the lower-limit-SOC-based correction coefficient $K_{LSOC}$ is calculated with reference to the graph illustrating the relationship between the lower limit SOC and the lower-limit-SOC-based correction coefficient $K_{LSOC}$ illustrated in FIG. 9. However, in a case where the lower-limit-SOC-based correction coefficient $K_{LSOC}$ is calculated using the lower limit SOC, the lower-limit-SOC-based correction coefficient $K_{LSOC}$ does not necessarily need to be calculated with reference to the graph illustrated in FIG. 9.

In the lead-acid battery system S and the lead-acid battery life estimation method according to the first, third, and fourth embodiments, the low-SOC-dwell-time-based correction coefficient $K_{t\_LSOC}$ is calculated with reference to the graph illustrating the relationship between the low SOC dwell time $t_{LSOC}$ and the low-SOC-dwell-time-based correction coefficient $K_{t\_LSOC}$ illustrated in FIG. 10. However, in a case where the low-SOC-dwell-time-based correction coefficient $K_{t\_LSOC}$ is calculated using the low SOC dwell time $t_{LSOC}$, the low-SOC-dwell-time-based correction coefficient $K_{t\_LSOC}$ does not necessarily need to be calculated with reference to the graph illustrated in FIG. 10.

Industrial Applicability

The lead-acid battery system and the lead-acid battery life estimation method according to the present invention can accurately estimate a he remaining life of a lead-acid battery by calculating a capacity turnover value during operation in consideration of at least one of a lower limit SOC or a low SOC dwell time, and thus can be extremely advantageously used in various industries.

Reference Signs List

1 BMU
2 EMS
3 PCS
11 Measurement unit
12 Recording unit
13 State determination unit
14 Setting unit
15 Communication unit
131 First current value acquisition unit
132 Discharge determination unit
133 Discharge current value integration unit
134 Second current value acquisition unit
135 Charge/discharge determination unit
136 Low SOC dwell time calculation unit
137 Lower limit SOC calculation unit
138 Capacity turnover value calculation unit
138a Previous capacity turnover value acquisition unit
138b Integrated discharge capacity acquisition unit
138c Rated capacity acquisition unit
138d Lower limit SOC acquisition unit
138e Lower-limit-SOC-based correction coefficient calculation unit
138f Low SOC dwell time acquisition unit
138g Low-SOC-dwell-time-based correction coefficient calculation unit
138h Capacity turnover value computation unit
139 Life estimation unit
231 First current value acquisition unit
232 Discharge determination unit
233 Discharge current value integration unit

234 Second current value acquisition unit

235 Charge/discharge determination unit

236 Lower limit SOC calculation unit

237 Capacity turnover value calculation unit

237a Previous capacity turnover value acquisition unit

237b Integrated discharge capacity acquisition unit

237c Rated capacity acquisition unit

237d Lower limit SOC acquisition unit

237e Lower-limit-SOC-based correction coefficient calculation unit

237f Capacity turnover value computation unit

331 First current value acquisition unit

332 Discharge determination unit

333 Discharge current value integration unit

334 Second current value acquisition unit

335 Charge/discharge determination unit

336 Low SOC dwell time calculation unit

337 Capacity turnover value calculation unit

337a Previous capacity turnover value acquisition unit

337b Integrated discharge capacity acquisition unit

337c Rated capacity acquisition unit

337d Low SOC dwell time acquisition unit

337e Low-SOC-dwell-time-based correction coefficient calculation unit

337f Capacity turnover value computation unit

338 Life estimation unit

431 First current value acquisition unit

432 Charge determination unit

433 Lower limit SOC calculation unit

434 Second current value acquisition unit

435 Discharge determination unit

436 Discharge current value integration unit

437 Third current value acquisition unit

438 Charge/discharge determination unit

439 Low SOC dwell time calculation unit

440 Capacity turnover value calculation unit

440a Previous capacity turnover value acquisition unit

440b Integrated discharge capacity acquisition unit

440c Rated capacity acquisition unit

440d Lower limit SOC acquisition unit

440e Lower-limit-SOC-based correction coefficient calculation unit

440f Low SOC dwell time acquisition unit

440g Low-SOC-dwell-time-based correction coefficient calculation unit

440h Capacity turnover value computation unit

441 Life estimation unit

B Lead-acid battery

S Lead-acid battery system

**Claims**

1.  A lead-acid battery system configured to estimate a remaining life of a lead-acid battery by comparing a capacity turnover value from a beginning to an end of life with a capacity turnover value during operation, the lead-acid battery system comprising:

    a capacity turnover value calculation unit configured to calculate the capacity turnover value during operation, wherein the capacity turnover value calculation unit calculates the capacity turnover value during operation by using at least one of a lower-limit-state-of-charge (SOC)-based correction coefficient calculated based on a lower limit SOC calculated by a lower limit SOC calculation unit configured to calculate the lower limit SOC which is an SOC having a smallest value when the lead-acid battery is charged and discharged once, respectively, or a low-SOC-dwell-time-based correction coefficient calculated based on a low SOC dwell time which is an elapsed time until a next discharge or charge starts when a discharge ends below a reference SOC.

2. The lead-acid battery system according to claim 1, wherein the lower limit SOC calculation unit calculates, as the lower limit SOC, an SOC after an end of a discharge of the lead-acid battery to be subjected to calculation of the capacity turnover value during operation, and the capacity turnover value calculation unit calculates the lower-limit-SOC-based correction coefficient based on the lower limit SOC calculated by the lower limit SOC calculation unit.

3. The lead-acid battery system according to claim 1, wherein the lower limit SOC calculation unit calculates, as the lower limit SOC, an SOC at a start of a charge immediately before a discharge of the lead-acid battery to be subjected to calculation of the capacity turnover value during operation, and the capacity turnover value calculation unit calculates the lower-limit-SOC-based correction coefficient based on the lower limit SOC calculated by the lower limit SOC calculation unit.

4. The lead-acid battery system according to any one of claims 1 to 3, wherein the lead-acid battery is a bipolar lead-acid battery.

5. A lead-acid battery life estimation method in which a remaining life of a lead-acid battery is estimated by comparing a capacity turnover value from a beginning to an end of life and a capacity turnover value during operation, the lead-acid battery life estimation method comprising:

a capacity turnover value calculation step of calculating the capacity turnover value during operation, wherein in the capacity turnover value calculation step, the capacity turnover value during operation is calculated using at least one of a lower-limit-SOC-based correction coefficient calculated based on a lower limit SOC calculated in a lower limit SOC calculation step of calculating the lower limit SOC which is an SOC having a smallest value when the lead-acid battery is charged and discharged once, respectively, or a low-SOC-dwell-time-based correction coefficient calculated based on a low SOC dwell time which is an elapsed time until a next discharge or charge starts when a discharge ends below a reference SOC.

6. The lead-acid battery life estimation method according to claim 5, wherein in the lower limit SOC calculation step, an SOC after an end of a discharge of the lead-acid battery to be subjected to calculation of the capacity turnover value during operation is calculated as the lower limit SOC, and in the capacity turnover value calculation step, the lower-limit-SOC-based correction coefficient is calculated based on the lower limit SOC calculated in the lower limit SOC calculation step.

7. The lead-acid battery life estimation method according to claim 5, wherein in the lower limit SOC calculation step, an SOC at a start of a charge immediately before a discharge of the lead-acid battery to be subjected to calculation of the capacity turnover value during operation is calculated as the lower limit SOC, and in the capacity turnover value calculation step, the lower-limit-SOC-based correction coefficient is calculated based on the lower limit SOC calculated in the lower limit SOC calculation step.

8. The lead-acid battery life estimation method according to any one of claims 5 to 7, wherein the lead-acid battery is a bipolar lead-acid battery.

# FIG. 1

# FIG. 2

# FIG. 3

# FIG. 4

# FIG. 5

# FIG. 6

FROM LOWER LIMIT SOC
CALCULATION UNIT

138

CAPACITY TURNOVER
VALUE CALCULATION UNIT

PREVIOUS CAPACITY TURNOVER
VALUE ACQUISITION UNIT — 138a

INTEGRATED DISCHARGE
CAPACITY ACQUISITION UNIT — 138b

RATED CAPACITY ACQUISITION UNIT — 138c

LOWER LIMIT SOC ACQUISITION UNIT — 138d

LOWER-LIMIT-SOC-BASED CORRECTION
COEFFICIENT CALCULATION UNIT — 138e

FROM
RECORDING
UNIT

LOWER SOC DWELL
TIME ACQUISITION UNIT — 138f

LOWER-SOC-DWELL-TIME-BASED
CORRECTION COEFFICIENT
CALCULATION UNIT — 138g

CAPACITY TURNOVER
VALUE COMPUTATION UNIT — 138h

TO LIFE ESTIMATION UNIT

# FIG. 7

```
                    ┌─────────────┐
                    │   START     │
                    └─────────────┘
                           │
                           ▼  ◄──────────────────────┐
              ┌──────────────────────────┐           │
              │ ACQUIRE FIRST CURRENT VALUE │──── S1   │
              └──────────────────────────┘           │
                           │                          │
                           ▼         S2         N     │
                    ◇───────────────────────◇ ────────┘
                    │  DETERMINE DISCHARGE  │
                    ◇───────────────────────◇
                           │ Y
                           ▼
              ┌──────────────────────────┐
              │ INTEGRATE DISCHARGE CURRENTS │──── S3
              └──────────────────────────┘
                           │
                           ▼
              ┌──────────────────────────┐
              │ CALCULATE SECOND CURRENT VALUE │──── S4
              └──────────────────────────┘
                           │
                           ▼              S5
         STOP      ◇──────────────────────◇   DISCHARGE
      ┌───────────│   DETERMINE          │───────────
      │            │ CHARGE/DISCHARGE     │
      ▼            ◇──────────────────────◇
 ┌──────────┐           │ CHARGE
 │ CURRENT  │           ▼
 │ VALUE =0 │── S6  ┌──────────────────────────┐
 └──────────┘        │ CALCULATE LOWER LIMIT SOC │──── S8
      │              └──────────────────────────┘
      ▼  S7                 │
 ┌──────────┐               ▼
 │ CALCULATE│        ┌──────────────────────────┐
 │ LOW SOC  │        │ CALCULATE CAPACITY        │──── S9
 │ TIME     │        │ TURNOVER VALUE            │
 └──────────┘        └──────────────────────────┘
      │                    │
      │                    ▼
      │              ┌──────────────────────────┐
      │              │ ESTIMATE LIFE             │──── S10
      │              └──────────────────────────┘
      │                    │
      │                    ▼
      │              ┌─────────────┐
      └─────────────►│    END      │
                     └─────────────┘
```

# FIG. 8

START

ACQUIRE PREVIOUS
CAPACITY TURNOVER VALUE — S91

ACQUIRE INTEGRATED
DISCHARGE CAPACITY VALUE — S92

ACQUIRE RATED CAPACITY — S93

ACQUIRE LOWER LIMIT SOC — S94

CALCULATE LOWER-LIMIT-SOC-BASED
CORRECTION COEFFICIENT — S95

ACQUIRE LOW SOC DWELL TIME — S96

ACQUIRE LOW-SOC-DWELL-TIME-BASED
CORRECTION COEFFICIENT — S97

COMPUTE CAPACITY
TURNOVER VALUE — S98

END

# FIG. 9

# FIG. 10

# FIG. 11

EP 4 474 842 A1

# FIG. 12

FROM LOWER LIMIT SOC
CALCULATION UNIT

237

CAPACITY TURNOVER
VALUE CALCULATION UNIT

PREVIOUS CAPACITY TURNOVER
VALUE ACQUISITION UNIT  —237a

INTEGRATED DISCHARGE
CAPACITY ACQUISITION UNIT  —237b

RATED CAPACITY ACQUISITION UNIT  —237c

LOWER LIMIT SOC ACQUISITION UNIT  —237d

LOWER-LIMIT-SOC-BASED CORRECTION
COEFFICIENT CALCULATION UNIT  —237e

CAPACITY TURNOVER
VALUE COMPUTATION UNIT  —237f

FROM
RECORDING
UNIT

TO LIFE ESTIMATION UNIT

# FIG. 13

START

ACQUIRE FIRST CURRENT VALUE — S101

S102
DETERMINE DISCHARGE — N

Y

INTEGRATE DISCHARGE CURRENTS — S103

ACQUIRE SECOND CURRENT VALUE — S104

S105
DETERMINE
CHARGE/DISCHARGE

STOP    DISCHARGE

S106

CURRENT VALUE = 0

CHARGE

CALCULATE LOWER LIMIT SOC — S107

CALCULATE CAPACITY
TURNOVER VALUE — S108

ESTIMATE LIFE — S109

END

# FIG. 14

```
        ┌─────────────┐
        │    START    │
        └─────────────┘
               │
               ▼
┌───────────────────────────┐
│    ACQUIRE PREVIOUS       │── S1081
│  CAPACITY TURNOVER VALUE  │
└───────────────────────────┘
               │
               ▼
┌───────────────────────────┐
│     ACQUIRE INTEGRATED    │── S1082
│  DISCHARGE CAPACITY VALUE │
└───────────────────────────┘
               │
               ▼
┌───────────────────────────┐
│    ACQUIRE RATED CAPACITY │── S1083
└───────────────────────────┘
               │
               ▼
┌───────────────────────────┐
│   ACQUIRE LOWER LIMIT SOC │── S1084
└───────────────────────────┘
               │
               ▼
┌───────────────────────────┐
│ CALCULATE LOWER-LIMIT-SOC-│── S1085
│    BASED CORRECTION       │
│       COEFFICIENT         │
└───────────────────────────┘
               │
               ▼
┌───────────────────────────┐
│     COMPUTE CAPACITY      │── S1086
│      TURNOVER VALUE       │
└───────────────────────────┘
               │
               ▼
        ┌─────────────┐
        │     END     │
        └─────────────┘
```

# FIG. 15

BMU

STATE DETERMINATION UNIT — 13

RECORDING UNIT — 12

FIRST CURRENT VALUE ACQUISITION UNIT — 331

DISCHARGE DETERMINATION UNIT — 332

DISCHARGE CURRENT VALUE INTEGRATION UNIT — 333

SECOND CURRENT VALUE ACQUISITION UNIT — 334

CHARGE/DISCHARGE DETERMINATION UNIT — 335

LOW SOC DWELL TIME CALCULATION UNIT — 336

CAPACITY TURNOVER VALUE CALCULATION UNIT — 337

LIFE ESTIMATION UNIT — 338

# FIG. 16

FROM LOWER LIMIT SOC
CALCULATION UNIT

337

CAPACITY TURNOVER
VALUE CALCULATION UNIT

PREVIOUS CAPACITY TURNOVER
VALUE ACQUISITION UNIT — 337a

INTEGRATED DISCHARGE
CAPACITY ACQUISITION UNIT — 337b

RATED CAPACITY ACQUISITION UNIT — 337c

FROM
RECORDING
UNIT

LOW SOC DWELL TIME ACQUISITION UNIT — 337d

LOW-SOC-DWELL-TIME-BASED CORRECTION
COEFFICIENT CALCULATION UNIT — 337e

CAPACITY TURNOVER
VALUE COMPUTATION UNIT — 337f

TO LIFE ESTIMATION UNIT

# FIG. 17

```
                    ┌─────────────┐
                    │    START    │
                    └──────┬──────┘
                           │
          ┌────────────────▼───────────────┐
          │  ACQUIRE FIRST CURRENT VALUE   │── S201
          └────────────────┬───────────────┘
                           │            S202
                    ┌──────▼──────┐           N
                  ◇ DETERMINE DISCHARGE ◇─────────┐
                    └──────┬──────┘                │
                           │ Y                     │
        ┌──────────────────▼───────────────┐       │
        │   INTEGRATE DISCHARGE CURRENTS   │── S203 │
        └──────────────────┬───────────────┘       │
                           │                       │
        ┌──────────────────▼───────────────┐       │
        │   ACQUIRE SECOND CURRENT VALUE   │── S204 │
        └──────────────────┬───────────────┘       │
                           │          S205         │
              STOP  ◇ DETERMINE CHARGE/DISCHARGE ◇  DISCHARGE
            ┌──────┘       └─────────┬─────────┘───────┘
       S206 │                        │ CHARGE
    ┌────────▼────────┐   ┌──────────▼──────────┐
    │ CURRENT VALUE=0 │   │ CALCULATE CAPACITY  │── S208
    └────────┬────────┘   │   TURNOVER VALUE    │
             │ S207       └──────────┬──────────┘
    ┌────────▼────────┐              │
    │    CALCULATE    │   ┌──────────▼──────────┐
    │  LOW SOC TIME   │   │    ESTIMATE LIFE    │── S209
    └─────────────────┘   └──────────┬──────────┘
                                     │
                              ┌──────▼──────┐
                              │     END     │
                              └─────────────┘
```

# FIG. 18

START

ACQUIRE PREVIOUS CAPACITY TURNOVER VALUE — S2081

ACQUIRE INTEGRATED DISCHARGE CAPACITY VALUE — S2082

ACQUIRE RATED CAPACITY — S2083

ACQUIRE LOW SOC DWELL TIME — S2084

CALCULATE LOW-SOC-DWELL-TIME-BASED CORRECTION COEFFICIENT — S2085

COMPUTE CAPACITY TURNOVER VALUE — S2086

END

# FIG. 19

# FIG. 20

# FIG. 21

FROM LOW SOC DWELL
TIME CALCULATION UNIT

440

CAPACITY TURNOVER
VALUE CALCULATION UNIT

| PREVIOUS CAPACITY TURNOVER VALUE ACQUISITION UNIT | 440a |

| INTEGRATED DISCHARGE CAPACITY ACQUISITION UNIT | 440b |

| RATED CAPACITY ACQUISITION UNIT | 440c |

| LOWER LIMIT SOC ACQUISITION UNIT | 440d |

| LOWER-LIMIT-SOC-BASED CORRECTION COEFFICIENT CALCULATION UNIT | 440e |

| LOW SOC DWELL TIME ACQUISITION UNIT | 440f |

| LOW-SOC-DWELL-TIME-BASED CORRECTION COEFFICIENT CALCULATION UNIT | 440g |

| CAPACITY TURNOVER VALUE COMPUTATION UNIT | 440h |

FROM
RECORDING
UNIT

TO LIFE ESTIMATION UNIT

# FIG. 22

START

ACQUIRE FIRST CURRENT VALUE — S401

DETERMINE CHARGE — S402
N
Y

CALCULATE LOWER LIMIT SOC — S403

ACQUIRE SECOND CURRENT VALUE — S404

DETERMINE DISCHARGE — S405
N
Y

INTEGRATE DISCHARGE CURRENTS — S406

ACQUIRE THIRD CURRENT VALUE — S407

DETERMINE CHARGE/DISCHARGE — S408
STOP
DISCHARGE
CHARGE

CURRENT VALUE =0 — S409

CALCULATE LOW SOC TIME — S410

CALCULATE CAPACITY TURNOVER VALUE — S411

ESTIMATE LIFE — S412

END

# FIG. 23

START

ACQUIRE PREVIOUS
CAPACITY TURNOVER VALUE — S4111

ACQUIRE INTEGRATED
DISCHARGE CAPACITY VALUE — S4112

ACQUIRE RATED CAPACITY — S4113

ACQUIRE LOWER LIMIT SOC — S4114

CALCULATE LOWER-LIMIT-SOC-BASED
CORRECTION COEFFICIENT — S4115

ACQUIRE LOW SOC DWELL TIME — S4116

CALCULATE LOW-SOC-DWELL-TIME-BASED
CORRECTION COEFFICIENT — S4117

COMPUTE CAPACITY
TURNOVER VALUE — S4118

END

# FIG. 24

# FIG. 25

# FIG. 26

# FIG. 27

# FIG. 28

# FIG. 29

| INTERNATIONAL SEARCH REPORT | International application No.<br>**PCT/JP2023/002260** |
|---|---|

**A. CLASSIFICATION OF SUBJECT MATTER**

*G01R 31/392*(2019.01)i; *G01R 31/379*(2019.01)i; *H01M 10/48*(2006.01)i; *H02J 7/00*(2006.01)i
FI: G01R31/392; G01R31/379; H01M10/48 P; H02J7/00 Y

According to International Patent Classification (IPC) or to both national classification and IPC

**B. FIELDS SEARCHED**

Minimum documentation searched (classification system followed by classification symbols)

G01R31/36-31/396; H01M10/42-10/48; H02J7/00; B60R16/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2003-161768 A (NTT POWER & BUILDING FACILITIES INC) 06 June 2003 (2003-06-06)<br>  paragraphs [0035]-[0049], fig. 2-5 | 1-8 |
| A | JP 2008-74257 A (MAZDA MOTOR CORP) 03 April 2008 (2008-04-03)<br>  entire text | 1-8 |
| A | JP 6430054 B1 (FURUKAWA BATTERY CO LTD) 28 November 2018 (2018-11-28)<br>  entire text | 1-8 |
| A | CN 103529399 A (HUNAN UNIVERSITY) 22 January 2014 (2014-01-22)<br>  paragraphs [0079]-[0090] | 1-8 |
| A | CN 112290637 A (ELECTRIC POWER RESEARCH INSTITUTE OF STATE GRID<br>LIAONING ELECTRIC POWER SUPPLY CO., LTD.) 29 January 2021 (2021-01-29)<br>  entire text | 1-8 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **08 March 2023** | **20 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/002260**

### C. DOCUMENTS CONSIDERED TO BE RELEVANT

| Category* | Citation of document, with indication, where appropriate, of the relevant passages | Relevant to claim No. |
|---|---|---|
| A | 中島秀仁；本間徳則；緑川淳；赤阪有一；柴田智史；吉田英明；橋本健介；荻野由涼；手塚渉；三浦優；古川淳；LAM, L. T.；菅田純雄，「ウルトラバッテリーの開発」，古河電工時報, February 2013, no. 131, pp. 21-27, ISSN 1348-1789, available on Internet<URL: https://www.furukawa.co.jp/jiho/fj131/fj131_04.pdf> (NAKAJIMA, Hidehito. HONMA, Tokunori. MIDORIKAWA, Kiyoshi. AKASAKA, Yuichi. SHIBATA, Satoshi. YOSHIDA, Hideaki. HASHIMOTO, Kensuke. OGINO, Yusuke. TEZUKA, Wataru. MIURA, Masaru. FURUKAWA, Jun. LAM, L. T. SUGATA, Sumio. Development of UltraBattery. Furukawa Review. March 2013, no. 43, pp. 2-9, ISSN 1348-1797, available on the Internet <URL: https://www.furukawa.co.jp/review/fr043/fr43_02.pdf>)<br>    section "2.2.2 Test results", fig. 4 | 1-8 |
| A | 野口博正；萬ケ原徹，「長寿命サイクルユース用制御弁式鉛蓄電池の開発」，第45回電池討論会講演要旨集, 27 November 2004, pp. 502-503, (NOGUCHI, Hiromasa. MANGAHARA, Tohru. Development of Long-life VRLA Battery for Deep Cycle Use. The 45th Battery Symposium in Japan.)<br>    section "1. Introduction" | 1-8 |
| P, A | WO 2022/030415 A1 (THE FURUKAWA ELECTRIC CO., LTD.) 10 February 2022 (2022-02-10)<br>    paragraph [0043] | 4, 8 |

INTERNATIONAL SEARCH REPORT
Information on patent family members

International application No.

**PCT/JP2023/002260**

| Patent document cited in search report | | | Publication date (day/month/year) | Patent family member(s) | Publication date (day/month/year) |
|---|---|---|---|---|---|
| JP | 2003-161768 | A | 06 June 2003 | (Family: none) | |
| JP | 2008-74257 | A | 03 April 2008 | (Family: none) | |
| JP | 6430054 | B1 | 28 November 2018 | WO 2019/225032 A1 | |
| CN | 103529399 | A | 22 January 2014 | (Family: none) | |
| CN | 112290637 | A | 29 January 2021 | (Family: none) | |
| WO | 2022/030415 | A1 | 10 February 2022 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H2288074 A